# EUROPEAN PATENT APPLICATION

(11) **EP 4 440 282 A1**
(43) Date of publication of application: **02.10.2024**
(21) Application number: 24164865.8
(22) Date of filing: 20.03.2024
(51) Int. Cl.: H10K 59/124, H10K 59/131, H10K 102/00

(54) **DISPLAY APPARATUS**

(30) Priority: 24.03.2023 KR 20230039084; 06.07.2023 KR 20230087894
(71) Applicant: Samsung Display Co., Ltd., Yongin-si, Gyeonggi-do 17113 (KR)
(72) Inventor: Ju, Jinho, 17113 Yongin-si, Gyeonggi-do (KR)
(74) Representative: Gulde & Partner

(57) **Abstract**

A display apparatus includes a substrate on which a display area and a peripheral area outside the display area are defined, a plurality of pixel circuits located in the display area, where each of the plurality of pixel circuits includes a thin-film transistor, a plurality of display elements connected to the plurality of pixel circuits, respectively, an inorganic partition wall located between the plurality of pixel circuits, and a bridge line crossing the inorganic partition wall to electrically connect from neighboring pixel circuits among the plurality of pixel circuits, which neighbor each other with the inorganic partition wall therebetween, to each other.

## Description

### BACKGROUND

### 1. Field

One or more embodiments relate to a display apparatus.

### 2. Description of the Related Art

In general, a display apparatus includes a plurality of pixels. Each pixel may include a display element and a pixel circuit for controlling an electrical signal applied to the display element. The pixel circuit may include a thin-film transistor, a storage capacitor, and a plurality of wirings.

Recently, display apparatuses have been used for various purposes. Also, as thicknesses and weights of display apparatuses have decreased, the range of applications of display apparatuses has increased. As the range of applications of display apparatuses has increased, various types of display apparatuses are being designed.

### SUMMARY

The present invention is set out in the appended set of claims, wherein the drawings and respective description relate to advantageous embodiments thereof.

In a display apparatus, when a thin-film transistor is damaged by external impact, a bright dot defect, in which a pixel including the damaged thin-film transistor has a higher luminance than neighboring pixels, may occur.

Accordingly, it was an object of the present invention to provide a display apparatus that is flexible but robust against external impact. Because the display apparatus according to embodiments is robust against external impact, the display apparatus may be foldable or rollable.

According to a first aspect, a display apparatus includes a substrate on which a display area and a peripheral area outside the display area are defined, a plurality of pixel circuits located in the display area, where each of the plurality of pixel circuits includes a thin-film transistor, a plurality of display elements connected to the plurality of pixel circuits, respectively, an inorganic partition wall located between the plurality of pixel circuits, and a bridge line crossing the inorganic partition wall to electrically connect neighboring pixel circuits among the plurality of pixel circuits, which neighbor each other with the inorganic partition wall therebetween, to each other.

In an embodiment, the display apparatus may further include an inorganic material layer located on the bridge line in the display area, and a bridge electrode located between the plurality of pixel circuits and the inorganic partition wall and overlapping the bridge line in a plan view, where each of the plurality of pixel circuits includes an extension wiring overlapping the bridge line and extending toward the inorganic partition wall, where the bridge electrode is connected to the bridge line through a contact hole defined through the inorganic material layer and is connected to the extension wiring.

In an embodiment, the inorganic partition wall may surround a first area of the display area where one or more pixel circuits from among the plurality of pixel circuits are located.

In an embodiment, the inorganic material layer may define an opening or a groove in a second area of the display area between the inorganic partition wall and the first area.

In an embodiment, the extension wiring may be located in a third area of the display area between the first area and the second area.

In an embodiment, the bridge electrode may be located in the third area.

In an embodiment, in the plan view, the bridge electrode may have an island shape.

In an embodiment, the thin-film transistor may include a semiconductor layer and a gate electrode overlapping the semiconductor layer, wherein the bridge line is located between the substrate and the semiconductor layer.

In an embodiment, the inorganic partition wall may include one or more conductive layers.

In an embodiment, the inorganic partition wall may include one or more semiconductor layers.

In an embodiment, the display apparatus may further include a first organic insulating layer covering the inorganic partition wall, and an inorganic pattern located on the first organic insulating layer and overlapping the inorganic partition wall.

In an embodiment, the display apparatus may further include a composite layer located between the plurality of pixel circuits and the plurality of display elements, where the composite layer may include one or more inorganic insulating layers and one or more organic insulating layers, which are stacked one on another.

In an embodiment, the display apparatus may further include a connection electrode layer located between the plurality of pixel circuits and the plurality of display elements, wherein the composite layer includes a first organic insulating layer covering the inorganic partition wall, a first inorganic insulating layer between the first organic insulating layer and the connection electrode layer, a second organic insulating layer on the connection electrode layer, and a second inorganic insulating layer between the second organic insulating layer and the plurality of display elements.

In an embodiment, the composite layer may further include a third organic insulating layer between the first organic insulating layer and the plurality of pixel circuits, a third inorganic insulating layer on the second organic insulating layer, and a fourth organic insulating layer between the third inorganic insulating layer and the second inorganic insulating layer.

In an embodiment, each of the plurality of display elements may include a pixel electrode, a counter electrode, and an emission layer located between the pixel electrode and the counter electrode, wherein the display apparatus further includes: an inorganic bank layer located on the pixel electrode and defining a pixel opening through which a central portion of the pixel electrode is exposed, and a metal bank layer located on the inorganic bank layer and defining a first opening overlapping the pixel opening.

In an embodiment, the metal bank layer may overlap the inorganic partition wall.

In an embodiment, the pixel opening and the first opening may be spaced apart from the inorganic partition wall, in a plan view.

In an embodiment, the metal bank layer may include a first sub-metal layer and a second sub-metal layer located on the first sub-metal layer, wherein the second sub-metal layer includes a tip protruding from a side surface of the first sub-metal layer defining the first opening toward a center of the first opening.

In an embodiment, the counter electrode may directly contact the side surface of the first sub-metal layer defining the first opening.

In an embodiment, in a plan view, the inorganic partition wall may have a lattice structure.

In an embodiment, in the plan view, the inorganic partition wall may have a hexagonal lattice structure.

Other features of embodiments of the disclosure will become more apparent from the drawings, the claims, and the detailed description.

### BRIEF DESCRIPTION OF THE DRAWINGS

The above and other features of certain embodiments will be more apparent from the following description taken in conjunction with the accompanying drawings, in which:
FIG. 1 is a plan view schematically illustrating a display apparatus, according to an embodiment;
FIGS. 2 and 3 are equivalent circuit diagrams illustrating a pixel included in a display apparatus, according to embodiments;
FIG. 4 is a cross-sectional view schematically illustrating a part of a display apparatus, according to an embodiment;
FIG. 5 is a plan view schematically illustrating a part of a display apparatus, according to an embodiment;
FIGS. 6 to 12 are plan views schematically illustrating layers of a part of a display apparatus, according to an embodiment;
FIGS. 13A and 13B are plan views schematically illustrating a part of a display apparatus, according to embodiments;
FIG. 14 is a cross-sectional view schematically illustrating a part of a display apparatus, according to an embodiment;
FIGS. 15 and 16 are cross-sectional views schematically illustrating a part of a display apparatus, according to embodiments;
FIG. 17 is a cross-sectional view schematically illustrating a part of a display apparatus, according to an embodiment; and
FIGS. 18A and 18B are views schematically illustrating a display apparatus, according to embodiments.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

As the disclosure allows for various changes and numerous embodiments, certain embodiments will be illustrated in the drawings and described in the detailed description. Effects and features of the disclosure, and methods for achieving them will be clarified with reference to embodiments described below in detail with reference to the drawings. However, the disclosure is not limited to the following embodiments and may be embodied in various forms.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein. Throughout the disclosure, the expression "at least one of a, b or c" or "at least one selected from a, b and c" indicates only a, only b, only c, both a and b, both a and c, both b and c, all of a, b, and c, or variations thereof.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be further understood that, when a layer, region, or component is referred to as being "on" another layer, region, or component, it may be directly on the other layer, region, or component, or may be indirectly on the other layer, region, or component with intervening layers, regions, or components therebetween.

In the specification, it will be understood that when a layer, a region, or a component is referred to as being "connected" to another layer, region, or component, it may be "directly connected" to the other layer, region, or component and/or may be "indirectly connected" to the other layer, region, or component with other layers, regions, or components interposed therebetween. For example, when a layer, a region, or a component is referred to as being "electrically connected," it may be directly electrically connected, and/or may be indirectly electrically connected with intervening layers, regions, or components therebetween.

"A and/or B" is used herein to select only A, select only B, or select both A and B. "At least one of A and B" or "At least one selected from A and B" is used to select only A, select only B, or select both A and B.

In the specification, the x-axis direction, the y-axis direction and the z-axis direction are not limited to directions corresponding to three axes of the rectangular coordinate system, and may be interpreted in a broader sense. For example, the x-axis direction, the y-axis direction, and the z-axis direction may be perpendicular to one another, or may represent different directions that are not perpendicular to one another.

When a certain embodiment may be implemented differently, a specific process order may be different from the described order. For example, two consecutively described processes may be performed substantially at the same time or may be performed in an order opposite to the described order.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

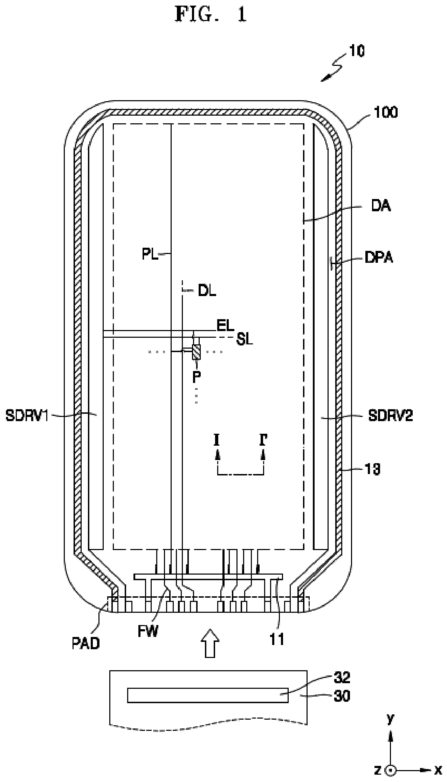

FIG. 1 is a plan view schematically illustrating a display apparatus, according to an embodiment.

Referring to FIG. 1, a display apparatus 10 according to an embodiment may include a substrate 100. In an embodiment, for example, the display apparatus 10 may include thin-film transistors and a capacitor, and the thin-film transistors and the capacitor may be implemented by semiconductor layers, conductive layers, and insulating layers located on the substrate 100. The display apparatus 10 may be any of various types of an electronic device including a display screen, such as a smartphone, a tablet, a laptop, a television, or a billboard. A plurality of pixel circuits are located in the display area DA, wherein each of the plurality of pixel circuits comprises a thin-film transistor.

The display apparatus 10includes a display area DA and a peripheral area DPA located outside the display area DA. Because the display apparatus 10 includes the substrate 100, the substrate 100 includes the display area DA and the peripheral area DPA.

In an embodiment, as shown in FIG. 1, the display area DA has a rectangular shape in which a width in a first direction (e.g., an x-axis direction) is less than a width in a second direction (e.g., a y-axis direction). However, the disclosure is not limited thereto. The display area DA may have any of various shapes such as a circular shape, an elliptical shape, a polygonal shape, or a specific shape. Here, a z-axis direction may be a direction perpendicular to the x-axis and y-axis directions, or a thickness direction of the display apparatus 10. Hereinafter, the x-axis direction, the y-axis direction and the z-axis direction may also be referred to as the x direction, the y direction and the z direction, respectively.

The display area DA is a portion where an image is displayed, and a plurality of pixels P may be located in the display area DA. Each pixel P may include a display element such as a light-emitting diode and a pixel circuit electrically connected to the display element. The pixel P may emit, for example, red light, green light, blue light, or white light. The pixel circuit of each pixel P may be connected to a scan line SL through which a scan signal is transmitted, an emission control line EL through which an emission control signal is transmitted, a data line DL through which a data signal is transmitted, and a driving voltage line PL through which a first driving voltage is supplied. Each pixel P may emit light in response to an electrical signal applied to the pixel circuit through the scan line SL, the emission control line EL, the data line DL, and the driving voltage line PL.

In an embodiment, the scan line SL and the emission control line EL may extend in the first direction (e.g., the x direction), and the data line DL may extend in the second direction (e.g., the y direction). Each of the scan lines SL and the emission control lines EL may be connected to the pixels P located in the same row. Each of the data lines DL may be connected to the pixels P located in the same column. The data lines DL may transmit a data signal to the pixels P located in a same column in synchronization with a scan signal.

Although an embodiment where the pixel P is connected to one scan line SL is shown in FIG. 1, this is merely an example, and one pixel P may be connected to two or more scan lines SL. A first scan driving circuit SDRV1 or a second scan driving circuit SDRV2 described below may supply two or more scan signals having different on-voltage application timings to corresponding scan lines.

The peripheral area DPA may be a non-display area where the pixels P are not located. Various wirings and outer circuits for transmitting an electrical signal to the display area DA may be located in the peripheral area DPA. In an embodiment, for example, the first scan driving circuit SDRV1, the second scan driving circuit SDRV2, a first driving voltage supply line 11, a second driving voltage supply line 13, and a terminal unit PAD may be located in the peripheral area DPA.

The first scan driving circuit SDRV1 and the second scan driving circuit SDRV2 may be located substantially parallel to each other with the display area DA therebetween. The first scan driving circuit SDRV1 may apply a scan signal to each of the pixels P through the scan line SL. In an embodiment, the first scan driving circuit SDRV1 may apply an emission control signal to each of the pixels P through the emission control line EL. The second scan driving circuit SDRV2 may apply a scan signal to each of the pixels P through the scan line SL. In some embodiments, some of the pixels P may be electrically connected to the first scan driving circuit SDRV1, and the rest of the pixels P may be electrically connected to the second scan driving circuit SDRV2. In some embodiments, the second scan driving circuit SDRV2 may be omitted.

The terminal unit PAD may be located on a side of the substrate 100. The terminal unit PAD may be exposed without being covered by an insulating layer, and may be connected to a display circuit board 30. A display driver 32 may be located on the display circuit board 30.

The display driver 32 may generate a control signal transmitted to the first scan driving circuit SDRV1 and the second scan driving circuit SDRV2. The display driver 32 may generate a data signal, and the generated data signal may be transmitted to the pixels P through a fan-out wiring FW and the data line DL electrically connected to the fan-out wiring FW.

The display driver 32 may supply a first driving voltage ELVDD to the first driving voltage supply line 11, and may supply a second driving voltage ELVSS to the second driving voltage supply line 13. The first driving voltage ELVDD may be applied the pixel circuit of the pixel P through the driving voltage line PL connected to the first driving voltage supply line 11, and the second driving voltage ELVSS may be applied to a counter electrode of a light-emitting diode connected to the second driving voltage supply line 13.

The first driving voltage supply line 11 may extend in the first direction (e.g., the x direction) to be provided on a side of the substrate 100. The second driving voltage supply line 13 may have a loop shape with one side open to surround at least a portion of the display area DA.

Although the display apparatus according to embodiments is an organic light-emitting display apparatus including an organic light-emitting diode as a display element, the display apparatus of the disclosure is not limited thereto. Alternatively, the display apparatus of the disclosure may be an inorganic light-emitting display apparatus or an inorganic electroluminescent (EL) display apparatus, or a quantum dot light-emitting display apparatus. For example, an emission layer of the display element included in the display apparatus may include an organic material or an inorganic material. Also, the display apparatus may include an emission layer, and quantum dots located in a path of light emitted from the emission layer.

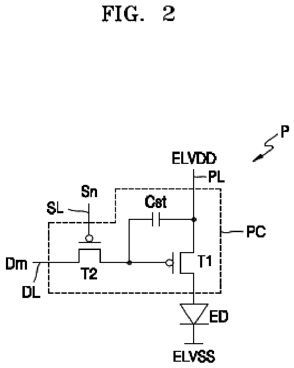

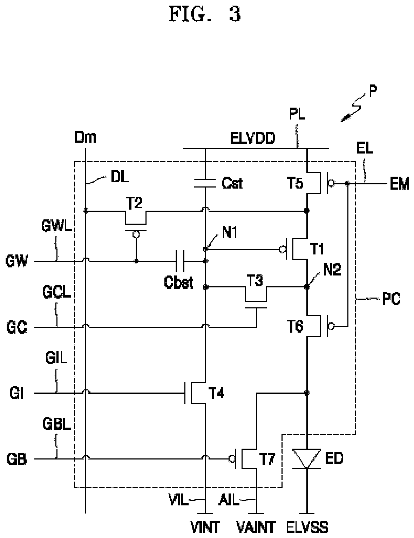

FIGS. 2 and 3 are equivalent circuit diagrams illustrating a pixel included in a display apparatus, according to embodiments.

Referring to FIG. 2, in an embodiment, the pixel P may include a light-emitting diode ED as a display element and a pixel circuit PC connected to the light-emitting diode ED. The pixel circuit PC may include a first transistor T1, a second transistor T2, and a storage capacitor Cst.

The second transistor T2 may be turned on in response to a scan signal Sn input through the scan line SL to transmit a data signal Dm input through the data line DL to the first transistor T1.

The storage capacitor Cst is connected to the second transistor T2 and the driving voltage line PL, and stores a voltage corresponding to a difference between a voltage received from the second transistor T2 and the first driving voltage ELVDD supplied to the driving voltage line PL.

The first transistor T1 may be connected to the driving voltage line PL and the storage capacitor Cst, and may control driving current flowing from the driving voltage line PL to the light-emitting diode ED based on a value of the voltage stored in the storage capacitor Cst. A counter electrode (e.g., a cathode) of the light-emitting diode ED may receive the second driving voltage ELVSS. The light-emitting diode ED may emit light having a certain luminance due to the driving current.

Referring to FIG. 3, in an alternative embodiment, the pixel circuit PC may include first to seventh transistors T1 to T7, the storage capacitor Cst, and a boost capacitor Cbst. In some embodiments, the boost capacitor Cbst may be omitted.

Some of the first to seventh transistors T1 to T7 may be n-channel metal-oxide-semiconductor field-effect transistor (MOSFETs) (hereinafter, will be referred to as NMOSs), and the rest of the first to seventh transistors T1 to T7 may be p-channel MOSFETs (hereinafter, will be referred to as PMOSs). In an embodiment, for example, the third transistor T3 and the fourth transistor T4 may be NMOSs, and the first transistor T1, the second transistor T2, the fifth transistor T5, the sixth transistor T6, and the seventh transistor T7 may be PMOSs.

The first transistor T1 may be a driving transistor that outputs driving current corresponding to the data signal Dm, and the second to seventh transistors T2 to T7 may be switching transistors that transmit signals. A first terminal (first electrode) of each of the first to seventh transistors T1 to T7 may be a source or a drain, and a second terminal (second electrode) may be a terminal different from the first terminal. In an embodiment, for example, where the first terminal is a drain, the second terminal may be a source.

The pixel circuit PC may be connected to signal lines. The signal lines may include scan lines, the emission control line EL, and the data line DL. The scan lines may include a first scan line GWL, a second scan line GCL, a third scan line GIL, and a fourth scan line GBL. The pixel circuit PC may be electrically connected to voltage lines, for example, the driving voltage line PL, a first initialization voltage line VIL, and a second initialization voltage line AIL.

The first transistor T1 may be a driving transistor. The first transistor T1 may include a gate connected to a first node N1, a first terminal connected to the driving voltage line PL via the fifth transistor T5, and a second terminal connected to a second node N2. The first transistor T1 may receive the data signal Dm based on a switching operation of the second transistor T2 and may control the amount of driving current flowing to the light-emitting diode ED.

The second transistor T2 (data write transistor) may be connected between the data line DL and the first terminal of the first transistor T1. The second transistor T2 may include a gate connected to the first scan line GWL, a first terminal connected to the data line DL, and a second terminal connected to the first terminal of the first transistor T1. The second transistor T2 may be turned on by a first scan signal GW transmitted through the first scan line GWL, to transmit the data signal Dm transmitted through the data line DL to the first transistor T1.

The third transistor T3 (compensation transistor) may be connected between the first node N1 and the second node N2. The third transistor T3 may include a gate connected to the second scan line GCL, a first terminal connected to the first node N1, and a second terminal connected to the second node N2. The third transistor T3 may be turned on by a second scan signal GC transmitted through the second scan line GCL, to diode-connect the gate and the second terminal of the first transistor T1.

The fourth transistor T4 (first initialization transistor) may include a gate connected to the third scan line GIL, a first terminal connected to the first node N1, and a second terminal connected to the first initialization voltage line VIL. The fourth transistor T4 may be turned on by a third scan signal GI transmitted through the third scan line GIL, to transmit a first initialization voltage VINT to the first node N1 and initialize a voltage of the gate of the first transistor T1.

The fifth transistor T5 (first emission control transistor) may include a gate connected to the emission control line EL, a first terminal connected to the driving voltage line PL, and a second terminal connected to the first terminal of the first transistor T1.

The sixth transistor T6 (second emission control transistor) may include a gate connected to the emission control line EL, a first terminal connected to the second node N2, and a second terminal connected to a pixel electrode (e.g., an anode) of the light-emitting diode ED.

The fifth transistor T5 and the sixth transistor T6 may be simultaneously turned on in response to an emission control signal EM transmitted through the emission control line EL, to allow driving current to flow to the light-emitting diode ED.

The seventh transistor T7 (second initialization transistor) may include a gate connected to the fourth scan line GBL, a first terminal connected to the pixel electrode of the light-emitting diode ED, and a second terminal connected to the second initialization voltage line AIL. The seventh transistor T7 may be turned on by a fourth scan signal GB transmitted through the fourth scan line GBL, to transmit a second initialization voltage VAINT to the pixel electrode of the light-emitting diode ED and initialize the pixel electrode of the light-emitting diode ED. In some embodiments, the fourth scan signal GB may be a first scan signal applied to a pixel circuit located in a previous row.

One electrode of the storage capacitor Cst may be connected to the driving voltage line PL, and the other electrode of the storage capacitor Cst may be connected to the first node N1. One electrode of the boost capacitor Cbst may be connected to the first scan line GWL, and the other electrode of the boost capacitor Cbst may be connected to the first node N1.

The light-emitting diode ED may include a counter electrode and the pixel electrode connected to the second node N2 via the sixth transistor T6, and the counter electrode may receive the second driving voltage ELVSS. The counter electrode may be a common electrode common to a plurality of pixels P. The light-emitting diode ED may receive driving current from the first transistor T1 and may emit light.

The pixel circuit PC is not limited to the number of thin-film transistors and capacitors and a circuit design described with reference to FIGS. 2 and 3 and the number of thin-film transistors and capacitors in the pixel circuit PC and the circuit design may be modified in various ways.

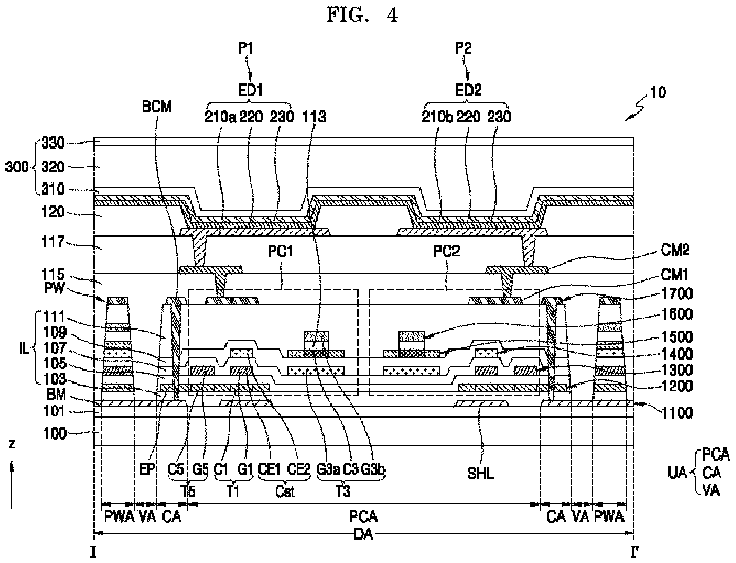

FIG. 4 is a cross-sectional view schematically illustrating a part of a display apparatus, according to an embodiment. Particularly, FIG. 4 is a cross-sectional view taken along line I-I' of the display apparatus 10 of FIG. 1.

Referring to FIG. 4, an embodiment of the display apparatus 10 includes the display area DA where a plurality of pixels are located. An inorganic partition wall PW is located between the plurality of pixel circuits. The display area DA may include a partition wall area PWA where the inorganic partition wall PW is located and unit areas UA surrounded by the inorganic partition wall PW. The partition wall area PWA may be located between neighboring unit areas UA. Each unit area UA may include a circuit area PCA (first area) where pixel circuits are located, a valley area VA (second area) between the partition wall area PWA and the circuit area PCA, and a connection area CA (third area) between the circuit area PCA and the valley area VA.

The plurality of pixels may include a first pixel P1 and a second pixel P2. The first pixel P1 may include a first light-emitting diode ED1 and a first pixel circuit PC1 electrically connected to the first light-emitting diode ED1. The second pixel P2 may include a second light-emitting diode ED2 and a second pixel circuit PC2 electrically connected to the second light-emitting diode ED2. The first pixel circuit PC1 and the second pixel circuit PC2 may be located in the circuit area PCA.

Although an embodiment where two pixel circuits (i.e., PC1 and PC2) are located in one circuit area PCA is shown in FIG. 4, the disclosure is not limited thereto. In some embodiments, only one pixel circuit may be located in one circuit area PCA. In other embodiments, three or more pixel circuits may be located in one circuit area PCA.

Each element of the display apparatus 10 may be located on the substrate 100.

The substrate 100 may include or be formed of an insulating material such as glass, quartz, or a polymer resin. The polymer resin may be polyethersulfone, polyacrylate, polyetherimide, polyethylene naphthalate, polyethylene terephthalate, polyphenylene sulfide, polyarylate, polyimide, polycarbonate, cellulose acetate propionate, or a mixture thereof.

In some embodiments, an inorganic insulating layer and an organic insulating layer may be located on the substrate 100. The substrate 100 may be a flexible substrate that is bendable, foldable, or rollable.

A barrier layer 101 may be located on the substrate 100. The barrier layer 101 may prevent or minimize penetration of impurities from the bottom of the substrate 100. The barrier layer 101 may include an inorganic material such as oxide or nitride, an organic material, or a composite material including an organic material and an inorganic material, and may have a single or multi-layer structure.

A lower metal layer 1100 may be located on the barrier layer 101. The lower metal layer 1100 may include molybdenum (Mo), aluminum (Al), copper (Cu), or titanium (Ti), and may have a single or multi-layer structure. In some embodiments, the lower metal layer 1100 may include a shield layer SHL and a bridge line BM.

The shield layer SHL may overlap a first channel region C1 of the first transistor T1 described below, to prevent or reduce degradation of characteristics of the first transistor T1 due to external light.

In an embodiment, the bridge line BM crosses the inorganic partition wall PW to electrically connect neighboring pixel circuits PC among the plurality of pixel circuits, which neighbor each other with the inorganic partition wall PW therebetween, to each other. The bridge line BM electrically connects neighboring pixel circuits with the inorganic partition wall PW therebetween. In an embodiment, for example, the bridge line BM may be formed to be common to neighboring unit areas UA with the partition wall area PWA therebetween. The bridge line BM may extend from the connection area CA through the valley area VA to cross the partition wall area PWA. The bridge line BM may be located between the inorganic partition wall PW and the substrate 100. The bridge line BM may be electrically connected to an extension wiring EP of the first pixel circuit PC1 through a bridge electrode BCM described below.

A buffer layer 103 may be located on the lower metal layer 1100. The buffer layer 103 may prevent or reduce penetration of impurities from the bottom of the substrate 100, and may provide a flat base surface to the first pixel circuit PC1 and the second pixel circuit PC2 located on the buffer layer 103. The buffer layer 103 may include an inorganic material such as oxide or nitride, and may have a single or multi-layer structure. In some embodiments, the buffer layer 103 may include silicon oxide, silicon nitride, and/or silicon oxynitride.

The first pixel circuit PC1 and the second pixel circuit PC2 may be located on the buffer layer 103. The first pixel circuit PC1 may include a first transistor T1, a third transistor T3, a fifth transistor T5, and a storage capacitor Cst. The first pixel circuit PC1 and the second pixel circuit PC2 may be line-symmetrical to each other in a plan view, and may have substantially a same configuration as each other. The features of the first pixel circuit PC1 described above may apply to the second pixel circuit PC2.

A first semiconductor layer 1200 may be located on the buffer layer 103. The first semiconductor layer 1200 may include a channel region, and impurity regions located on opposing sides of the channel region. One of the impurity regions located on opposing sides of the channel region may be a source region and the other thereof may be a drain region. The first semiconductor layer 1200 may include or define the first channel region C1 of the first transistor T1 and a fifth channel region C5 of the fifth transistor T5.

The first semiconductor layer 1200 may further include or define the extension wiring EP located in the connection area CA. The extension wiring EP may be a part of an impurity region extending to one side of the fifth channel region C5 of the fifth transistor T5. The first semiconductor layer 1200 may include a silicon-based semiconductor material, for example, polysilicon. In some embodiments, the first semiconductor layer 1200 may include amorphous silicon.

Although, for convenience of illustration, only the extension wiring EP located in the first semiconductor layer 1200 is illustrated in FIG. 4, the display apparatus 10 may include a plurality of extension wirings, and each of the extension wirings may be located in the first semiconductor layer 1200, a first conductive layer 1300, a second conductive layer 1400, a third conductive layer 1600, or a fourth conductive layer 1700.

A first gate insulating layer 105 may be located on the first semiconductor layer 1200. The first gate insulating layer 105 may include an inorganic insulating material such as silicon oxide, silicon nitride, silicon oxynitride, aluminum oxide, titanium oxide, tantalum oxide, hafnium oxide, and/or zinc oxide. The first gate insulating layer 105 may have a single or multi-layer structure, each layer therein including at least one selected from the above inorganic insulating materials.

The first conductive layer 1300 may be located on the first gate insulating layer 105. The first conductive layer 1300 may include or define a first gate electrode G1 of the first transistor T1 and a fifth gate electrode G5 of the fifth transistor T5. The first gate electrode G1 may overlap the first channel region C1 of the first transistor T1. The fifth gate electrode G5 may overlap the fifth channel region C5 of the fifth transistor T5. The first conductive layer 1300 may include molybdenum (Mo), aluminum (Al), copper (Cu), or titanium (Ti) and may have a single or multi-layer structure.

A second gate insulating layer 107 may be located on the first conductive layer 1300. The second gate insulating layer 107 may include an inorganic insulating material such as silicon oxide, silicon nitride, silicon oxynitride, aluminum oxide, titanium oxide, tantalum oxide, hafnium oxide, and/or zinc oxide. The second gate insulating layer 107 may have a single or multi-layer structure, each layer therein including at least one selected from the above inorganic insulating materials.

The second conductive layer 1400 may be located on the second gate insulating layer 107. The second conductive layer 1400 may include or define an upper electrode CE2 of the storage capacitor Cst and a third lower gate electrode G3a of the third transistor T3. The second conductive layer 1400 may include molybdenum (Mo), aluminum (Al), copper (Cu), or titanium (Ti), and may have a single or multi-layer structure.

The upper electrode CE2 of the storage capacitor Cst may overlap the first gate electrode G1 of the first transistor T1 in the z direction or in a plan view. The first gate electrode G1 may be integrally provided or formed with a lower electrode CE1 of the storage capacitor Cst as a single unitary and indivisible part. The lower electrode CE1 and the upper electrode CE2 may constitute (or collectively define) the storage capacitor Cst.

The third lower gate electrode G3a of the third transistor T3 may overlap a third channel region C3 of the third transistor T3 described below. A width of the third lower gate electrode G3a may be greater than a width of the third channel region C3. The third lower gate electrode G3a may prevent or reduce degradation of characteristics of the third transistor T3 due to external light.

A first interlayer insulating layer 109 may be located on the second conductive layer 1400. The first interlayer insulating layer 109 may include an inorganic insulating material such as silicon oxide, silicon nitride, silicon oxynitride, aluminum oxide, titanium oxide, tantalum oxide, hafnium oxide, and/or zinc oxide. The first interlayer insulating layer 109 may have a single or multi-layer structure, each layer therein including at least one selected from the above inorganic insulating materials.

A second semiconductor layer 1500 may be located on the first interlayer insulating layer 109. The second semiconductor layer 1500 may include a channel region and impurity regions located on opposing sides of the channel region. The second semiconductor layer 1500 may include the third channel region C3 of the third transistor T3. The second semiconductor layer 1500 may include an oxide-based semiconductor material, for example, a Zn oxide-based material. The second semiconductor layer 1500 may include or be formed of an In-Ga-Zn-O (IGZO), In-Sn-Zn-O (ITZO), or In-Ga-Sn-Zn-O (IGTZO) semiconductor containing a metal such as indium (In), gallium (Ga), or tin (Sn) in ZnO.

A third gate insulating layer 113 may be located on the second semiconductor layer 1500. The third gate insulating layer 113 may include an inorganic insulating material such as silicon oxide, silicon nitride, silicon oxynitride, aluminum oxide, titanium oxide, tantalum oxide, hafnium oxide, and/or zinc oxide. The third gate insulating layer 113 may have a single or multi-layer structure, each layer therein including at least one selected from the above inorganic insulating materials. The third gate insulating layer 113 may be formed by being patterned together with the third conductive layer 1600 described below. The third gate insulating layer 113 may have a shape corresponding to a shape of the third conductive layer 1600.

The third conductive layer 1600 may be located on the third gate insulating layer 113. The third conductive layer 1600 may include or define a third upper gate electrode G3b of the third transistor T3. The third upper gate electrode G3b may overlap the third channel region C3 of the third transistor T3. The third upper gate electrode G3b may face the third lower gate electrode G3a with the second semiconductor layer 1500 therebetween. The third conductive layer 1600 may include molybdenum (Mo), aluminum (Al), copper (Cu), or titanium (Ti), and may have a single or multi-layer structure.

A second interlayer insulating layer 111 may be located on the third conductive layer 1600. The second interlayer insulating layer 111 may include an inorganic insulating material such as silicon oxide, silicon nitride, silicon oxynitride, aluminum oxide, titanium oxide, tantalum oxide, hafnium oxide, and/or zinc oxide. The second interlayer insulating layer 111 may have a single or multi-layer structure, each layer therein including at least one selected from the above inorganic insulating materials.

Inorganic insulating layers located on the lower metal layer 1100 may be defined as an inorganic material layer IL. In an embodiment, for example, the inorganic material layer IL may include the buffer layer 103, the first gate insulating layer 105, the second gate insulating layer 107, the first interlayer insulating layer 109, the second interlayer insulating layer 111, and the third gate insulating layer 113.

The inorganic material layer IL may define (or be provided with) an opening or a groove in the valley area VA. In an embodiment, for example, as shown in FIG. 4, the buffer layer 103, the first gate insulating layer 105, the second gate insulating layer 107, the first interlayer insulating layer 109, and the second interlayer insulating layer 111 may respectively define openings overlapping the valley area VA. The openings defined in the inorganic material layer IL may be formed to expose the bridge line BM.

The inorganic material layer IL may define any of various types of grooves. The groove may refer to a trench formed in the inorganic material layer IL. In such an embodiment, various modifications may be made. In some embodiments, a part of the buffer layer 103 may remain without being removed.

In an embodiment, a part of the inorganic material layer IL may be removed by using a mask process or an etching process to form the opening or the groove of the inorganic material layer IL. In an embodiment, the etching process may be a dry etching process. In such an embodiment, the bridge line BM may function as an etch stopper for protecting layers under the bridge line BM. Due to the opening or the groove of the inorganic material layer IL, the inorganic partition wall PW may be spaced apart from the inorganic material layer IL, and propagation of cracks to neighboring pixel circuits during external impact may be effectively prevented or substantially reduced.

As a depth of the opening or the groove of the inorganic material layer IL increases, robustness of the display apparatus 10 against external impact may increase. In embodiments, because there is no signal wiring crossing the opening or the groove except for the bridge line BM included in the lower metal layer 1100, the opening or the groove may be formed up to a top surface of the lower metal layer 1100.

In a comparative example, when a pen drop test was performed on a display apparatus having no opening or groove defined in an inorganic material layer, a bright dot defect occurred when a pen was dropped from a height of about 7.5 centimeter (cm) or higher. In another comparative example, when a pen drop test was performed on a display apparatus in which an opening or a groove defined in an inorganic material layer is formed up to a top surface of a second semiconductor layer, a bright dot defect occurred when a pen was dropped from a height of about 8.4 cm or higher. In another comparative example, when a pen drop test was performed on a display apparatus in which an opening or a groove defined in an inorganic material layer is formed up to a top surface of a first semiconductor layer, a bright dot defect occurred when a pen was dropped from a height of about 9.9 cm or higher. According to an embodiment, when a pen drop test was performed on the display apparatus in which the opening defined in the inorganic material layer IL is formed up to a top surface of the lower metal layer 1100, a bright dot defect occurred when a pen was dropped from a height of about 12.5 cm or higher. Accordingly, it is found that as a depth of the opening or the groove defined in the inorganic material layer IL increases, robustness of the display apparatus 10 against external impact increases.

The fourth conductive layer 1700 may be located on the inorganic material layer IL. The fourth conductive layer 1700 may include a first connection electrode CM1 and the bridge electrode BCM. The bridge electrode BCM may arrange between the pixel circuits and the inorganic partition wall PW. The bridge electrode BCM may be connected to the bridge line BM through a contact hole defined through the inorganic material layer IL and the extension wiring EP. The bridge electrode BCM may contact a side surface of the extension wiring EP defining a contact hole, to electrically connect the first semiconductor layer 1200 of the first pixel circuit PC1 to the bridge line BM. The fourth conductive layer 1700 may include molybdenum (Mo), aluminum (Al), copper (Cu), or titanium (Ti), and may have a single or multi-layer structure.

In an embodiment, the inorganic partition wall PW may surround a first area of the display area DA where one or more pixel circuits PC among the plurality of pixel circuits are located. The inorganic partition wall PW may be located in the partition wall area PWA, and may have a loop shape surrounding the circuit area PCA. The inorganic partition wall PW may be located on the bridge line BM, and may include a plurality of sub-layers. The sub-layers and layers constituting the first pixel circuit PC1 may be formed in a same process and may include a same material.

In some embodiments, the inorganic partition wall PW may include one or more conductive layers. In an embodiment, for example, as shown in FIG. 4, one or more conductive layers selected from the first conductive layer 1300, the second conductive layer 1400, the third conductive layer 1600, and the fourth conductive layer 1700 may include a sub-layer of the inorganic partition wall PW.

In some embodiments, the inorganic partition wall PW may include one or more semiconductor layers. In an embodiment, for example, as shown in FIG. 4, one or more semiconductor layers selected from the first semiconductor layer 1200 and the second semiconductor layer 1500 may include a sub-layer of the inorganic partition wall PW.

In an embodiment, although the inorganic partition wall PW includes the buffer layer 103, the first gate insulating layer 105, the second gate insulating layer 107, the first interlayer insulating layer 109, the third gate insulating layer 113, and the second interlayer insulating layer 111 as shown in FIG. 4, the disclosure is not limited thereto. Alternatively, the inorganic partition wall PW may not include some of the buffer layer 103, the first gate insulating layer 105, the second gate insulating layer 107, the first interlayer insulating layer 109, the third gate insulating layer 113, and the second interlayer insulating layer 111.

In an embodiment, although the inorganic partition wall PW includes sub-layers respectively included in the first semiconductor layer 1200, the first conductive layer 1300, the second conductive layer 1400, the second semiconductor layer 1500, the third conductive layer 1600, and the fourth conductive layer 1700 as shown in FIG. 4, at least some of the sub-layers may be omitted.

According to embodiments, because the inorganic partition wall PW for protecting the first and second pixel circuits PC1 and PC2 in the circuit area PCA is provided or located, the display apparatus 10 that is robust against external impact may be implemented.

A first planarization layer 115 may be located on the fourth conductive layer 1700. The first planarization layer 115 may include an organic insulating material. The first planarization layer 115 may include a general-purpose polymer such as benzocyclobutene (BCB), polyimide, hexamethyldisiloxane (HMDSO), polymethyl methacrylate (PMMA) or polystyrene (PS), a polymer derivative having a phenol-based group, an acrylic polymer, an imide-based polymer, an aryl ether-based polymer, an amide-based polymer, a fluorinated polymer, a p-xylene-based polymer, or a vinyl alcohol-based polymer. The first planarization layer 115 may provide a flat base surface to elements located on the first planarization layer 115.

A second connection electrode CM2 may be located on the first planarization layer 115. The second connection electrode CM2 may be connected to the first connection electrode CM1 through a contact hole defined through the first planarization layer 115. The first connection electrode CM1 may be connected to an impurity region of the first semiconductor layer 1200 through a contact hole defined through the first gate insulating layer 105, the second gate insulating layer 107, the first interlayer insulating layer 109, and the second interlayer insulating layer 111. Accordingly, the first pixel circuit PC1 may be electrically connected to a first pixel electrode 210a of the first light-emitting diode ED1 through the first connection electrode CM1 and the second connection electrode CM2. The second connection electrode CM2 may include molybdenum (Mo), aluminum (Al), copper (Cu), or titanium (Ti), and may have a single or multi-layer structure.

In some embodiments, the first planarization layer 115 may fill the opening or the groove of the inorganic material layer IL. In other embodiments, the opening or the groove of the inorganic material layer IL may be filled with an organic material layer located under the first planarization layer 115.

A second planarization layer 117 may be located on the second connection electrode CM2. The second planarization layer 117 may include an organic insulating material. The second planarization layer 117 may include a general-purpose polymer such as benzocyclobutene (BCB), polyimide, hexamethyldisiloxane (HMDSO), polymethyl methacrylate (PMMA) or polystyrene (PS), a polymer derivative having a phenol-based group, an acrylic polymer, an imide-based polymer, an aryl ether-based polymer, an amide-based polymer, a fluorinated polymer, a p-xylene-based polymer, or a vinyl alcohol-based polymer.

In an embodiment, when the first planarization layer 115 and/or the second planarization layer 117 is formed, chemical mechanical polishing may be performed to provide a flat top surface.

The first light-emitting diode ED1 electrically connected to the first pixel circuit PC1 and the second light-emitting diode ED2 electrically connected to the second pixel circuit PC2 may be located on the second planarization layer 117. The first light-emitting diode ED1 may include the first pixel electrode 210a, a counter electrode 230, and an intermediate layer 220 located between the first pixel electrode 210a and the counter electrode 230 and including an emission layer. The second light-emitting diode ED2 may include a second pixel electrode 210b, the counter electrode 230, and the intermediate layer 220 located between the second pixel electrode 210b and the counter electrode 230 and including an emission layer. The first light-emitting diode ED1 and the second light-emitting diode ED2 may have substantially the same configuration as or similar configurations to each other. The features of the first light-emitting diode ED1 described above may apply to the second light-emitting diode ED2.

The first pixel electrode 210a may be located on the second planarization layer 117. The first pixel electrode 210a may be connected to the second connection electrode CM2 through a contact hole defined through the second planarization layer 117. The first pixel electrode 210a may be a (semi-)transmissive electrode or a reflective electrode. In some embodiments, the first pixel electrode 210a may include a reflective layer including or formed of silver (Ag), magnesium (Mg), aluminum (Al), platinum (Pt), palladium (Pd), gold (Au), nickel (Ni), neodymium (Nd), iridium (Ir), chromium (Cr), or a compound thereof, and a transparent or semi-transparent electrode layer formed on the reflective layer. The transparent or semi-transparent electrode layer may include at least one selected from indium tin oxide (ITO), indium zinc oxide (IZO), zinc oxide (ZnO), indium oxide (In₂O₃), indium gallium oxide (IGO), and aluminum zinc oxide (AZO). In some embodiments, the first pixel electrode 210a may include ITO/Ag/ITO.

A pixel-defining film 120 may be located on the first pixel electrode 210a to cover an edge of the first pixel electrode 210a. The pixel-defining film 120 may define a pixel opening through which a central portion of the first pixel electrode 210a is exposed. An emission area of the first light-emitting diode ED1 may be defined by the pixel opening.

The pixel-defining film 120 may increase a distance between an edge of the first pixel electrode 210a and the counter electrode 230, thereby preventing an arc or the like from occurring at the edge of the first pixel electrode 210a.

The intermediate layer 220 may be located on the first pixel electrode 21 0a, the second pixel electrode 210b and the pixel-defining film 120. The intermediate layer 220 may include a first emission layer formed to correspond to the first pixel electrode 210a and a second emission layer formed to correspond to the second pixel electrode 210b. Each of the first emission layer and the second emission layer may include a high molecular weight material or a low molecular weight material, and may emit red light, green light, blue light, or white light. The intermediate layer 220 may include a functional layer located over and/or under the first emission layer and the second emission layer. The functional layer may include a hole transport layer (HTL), a hole injection layer (HIL), an electron transport layer (ETL), and/or an electron injection layer (EIL). The functional layer may be integrally or commonly formed over a plurality of light-emitting diodes (e.g., ED1 and ED2) located in the display area DA.

The counter electrode 230 may be located on the intermediate layer 220. The counter electrode 230 may include a conductive material having a low work function. In an embodiment, for example, the counter electrode 230 may include a (semi-)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. In some embodiments, the counter electrode 230 may further include a layer such as ITO, IZO, ZnO, or In₂O₃ on the (semi-)transparent layer including the above material. The counter electrode 230 may be integrally or commonly formed over a plurality of light-emitting diodes (e.g., ED1 and ED2) located in the display area DA.

A capping layer may be located on the counter electrode 230. The capping layer may protect the counter electrode 230 and may improve light extraction efficiency. A refractive index of the capping layer may be higher than a refractive index of the counter electrode 230. The capping layer may include an organic material, or may include an inorganic material such as LiF.

An encapsulation layer 300 may be located to cover the first light-emitting diode ED1 and the second light-emitting diode ED2. The encapsulation layer 300 may include at least one inorganic encapsulation layer and at least one organic encapsulation layer. In an embodiment, for example, the encapsulation layer 300 may include a first inorganic encapsulation layer 310, an organic encapsulation layer 320, and a second inorganic encapsulation layer 330 as shown in FIG. 4.

Each of the first inorganic encapsulation layer 310 and the second inorganic encapsulation layer 330 may include an inorganic material such as silicon oxide, silicon nitride, and/or silicon oxynitride, and may have a single or multi-layer structure. In some embodiments, the first inorganic encapsulation layer 310 and the second inorganic encapsulation layer 330 may be formed by using chemical vapor deposition. The organic encapsulation layer 320 may include a polymer-based material. Examples of the polymer-based material may include an acrylic resin, an epoxy resin, polyimide, and polyethylene.

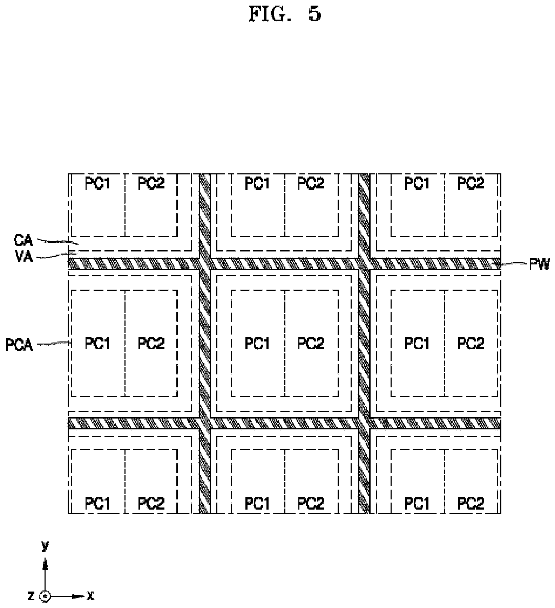

FIG. 5 is a plan view schematically illustrating a part of a display apparatus, according to an embodiment.

Referring to FIG. 5, in an embodiment, the inorganic partition wall PW may surround the circuit area PCA in which the first and second pixel circuits PC1 and PC2 are located.

One or more pixel circuits may be located in the circuit area PCA. In an embodiment, for example, the first pixel circuit PC1 and the second pixel circuit PC2 may be located in the circuit area PCA. The first pixel circuit PC1 may be electrically connected to a first light-emitting diode ED1 to implement a first pixel. The second pixel circuit PC2 may be electrically connected to a second light-emitting diode ED2 to implement a second pixel.

According to an embodiment, in a plan view, the inorganic partition wall PW may have a lattice structure. The inorganic partition wall PW may have a lattice structure over the entire display area. The inorganic partition wall PW may be formed by crossing a partition wall extending in the first direction (e.g., the x direction) and a partition wall extending in the second direction (e.g., the y direction). That is, the inorganic partition wall PW may have a quadrangular lattice structure. As described above, an area surrounded by the inorganic partition wall PW may be defined as a unit area.

The inorganic partition wall PW may include sub-layers including an inorganic material. Because the inorganic partition wall PW has a high modulus, the inorganic partition wall PW may protect the first and second pixel circuits PC1 and PC2 from external impact.

The valley area VA may be located or defined between the inorganic partition wall PW and the circuit area PCA. As described with reference to FIG. 4, an opening or a groove defined in the inorganic material layer IL may be located in the valley area VA. Because the opening or the groove defined in the inorganic material layer IL is filled with an organic material layer to distribute stress applied to the display apparatus, impact resistance may be improved. Also, the opening or the groove defined in the inorganic material layer IL may prevent or reduce propagation of the cracks to the inorganic material layer IL of a neighboring circuit area PCA when cracks occur in the inorganic material layer IL of one circuit area PCA. In some embodiments, the opening or the groove defined in the inorganic material layer IL may be omitted.

The connection area CA may be located between the circuit area PCA and the valley area VA. As described with reference to FIG. 4, the extension wirings EP and the bridge electrodes BCM for electrically connecting elements of the first and second pixel circuits PC1 and PC2 to the bridge line BM may be located in connection area CA.

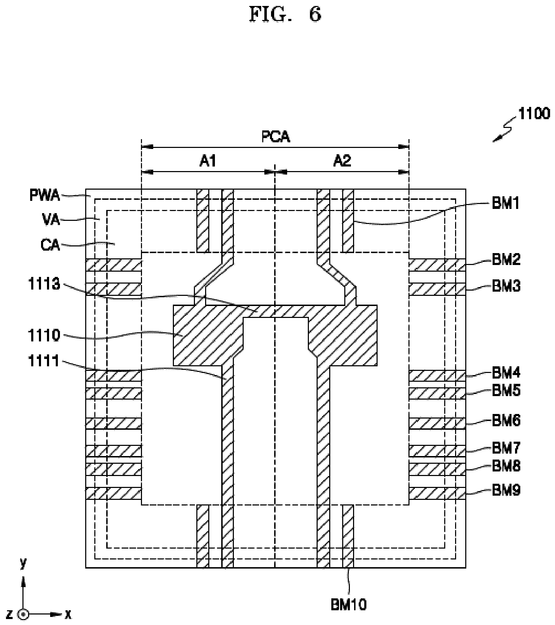

FIGS. 6 to 12 are plan views schematically illustrating layers of a part of a display apparatus, according to an embodiment.

Referring to FIGS. 6 to 12, the circuit area PCA may include a first sub-area A1 in which a first pixel circuit PC1 is located and a second sub-area A2 in which a second pixel circuit PC2 is located. The first pixel circuit PC1 located in the first sub-area A1 and the second pixel circuit PC2 located in the second sub-area A2 may be line-symmetrical to each other and may have substantially a same configuration as each other. The first pixel circuit PC1 located in the first sub-area A1 will be mainly described, and any repetitive detailed description of the second pixel circuit PC2 located in the second sub-area A2 will be omitted or simplified.

The partition wall area PWA may be located to surround the circuit area PCA, and the valley area VA and the connection area CA may be located between the circuit area PCA and the partition wall area PWA. The valley area VA may be adjacent to the partition wall area PWA, and the connection area CA may be adjacent to the circuit area PCA.

In an embodiment, as shown in FIG. 6, the lower metal layer 1100 may include a shield layer 1110, a first wiring 1111, a second wiring 1113, and first to tenth bridge lines BM1 to BM10.

The shield layer 1110 may be located in the circuit area PCA, and may overlap a first channel region C1 of the first semiconductor layer 1200. The shield layer 1110 may correspond to the shield layer SHL described with reference to FIG. 4.

The first wiring 1111 may extend in the second direction (e.g., the y direction) to connect neighboring shield layers 1110 in the second direction (e.g., the y direction) to each other. The first wiring 1111 may extend from the circuit area PCA, may cross the connection area CA, the valley area VA, and the partition wall area PWA, and may be connected to the shield layer 1110 of a neighboring pixel circuit with an inorganic partition wall therebetween. In some embodiments, a constant voltage such as the first driving voltage ELVDD may be applied to the shield layer 1110 through the first wiring 1111. Because a constant voltage is applied to the shield layer 1110, occurrence of defects caused by static electricity or the like may be effectively prevented or substantially reduced. The second wiring 1113 may extend in the first direction (e.g., the x direction) to connect neighboring shield layers 1110 in the first direction (e.g., the x direction) to each other.

The first to tenth bridge lines BM1 to BM10 may be located to cross the connection area CA, the valley area VA, and the partition wall area PWA from a boundary of the circuit area PCA. A common bridge line may be located in unit areas that are adjacent to each other, to electrically connect neighboring pixel circuits with an inorganic partition wall therebetween. In an embodiment, for example, the first and tenth bridge lines BM1 and BM10 may extend in the second direction (e.g., the y direction), to electrically connect neighboring pixel circuits in the second direction (e.g., the y direction) with an inorganic partition wall therebetween. The second to ninth bridge lines BM2 to BM9 may extend in the first direction (e.g., the x direction), to electrically connect neighboring pixel circuits in the first direction (e.g., the x direction) with an inorganic partition wall therebetween. Each of the first to tenth bridge lines BM1 to BM10 may overlap a corresponding extension wiring and bridge electrode.

Because the first to tenth bridge lines BM1 to BM10 are located in the lower metal layer 1100, an opening or a groove of the inorganic material layer IL (see FIG. 4) may be formed up to a top surface of the lower metal layer 1100.

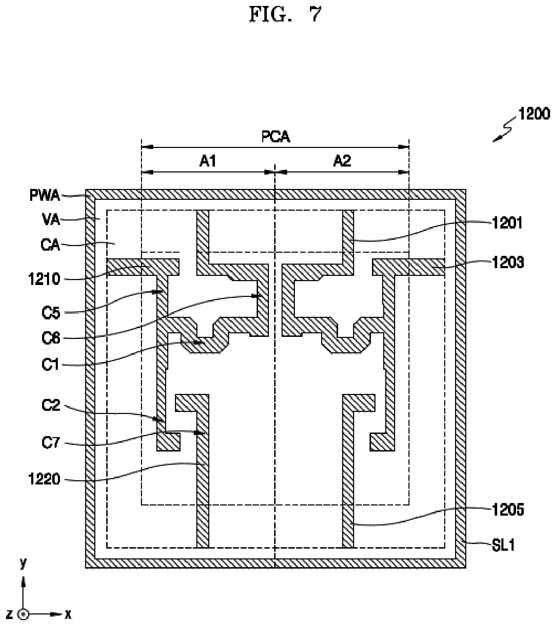

In an embodiment, as shown in FIG. 7, the first semiconductor layer 1200 may be located on the lower metal layer 1100. The first semiconductor layer 1200 may include a first semiconductor pattern 1210, a second semiconductor pattern 1220, a first extension wiring 1201, a second extension wiring 1203, a third extension wiring 1205, and a first sub-layer SL1. The first semiconductor pattern 1210 and the second semiconductor pattern 1220 may be located in the circuit area PCA, and the first extension wiring 1201, the second extension wiring 1203, and the third extension wiring 1205 may be located in the connection area CA.

The first semiconductor pattern 1210 may include a first channel region C1, a second channel region C2, a fifth channel region C5, and a sixth channel region C6, and the second semiconductor pattern 1220 may include a seventh channel region C7. Impurity regions may be located on opposing sides of the first channel region C1, the second channel region C2, the fifth channel region C5, the sixth channel region C6, and the seventh channel region C7. Each of the impurity regions may be a source region or a drain region of a corresponding transistor.

The first extension wiring 1201 may extend from the first semiconductor pattern 1210 in the second direction (e.g., the y direction), and may overlap the first bridge line BM1. The second extension wiring 1203 may extend from the first semiconductor pattern 1210 in the first direction (e.g., the x direction), and may overlap the second bridge line BM2. The third extension wiring 1205 may extend from the second semiconductor pattern 1220 in the second direction (e.g., the y direction), and may overlap the tenth bridge line BM 10. The first extension wiring 1201 and the second extension wiring 1203 may be integrally provided or formed with the first semiconductor pattern 1210 as a single unitary and indivisible part, and the third extension wiring 1205 may be integrally provided or formed with the second semiconductor pattern 1220 as a single unitary and indivisible part.

The first sub-layer SL1 may be located in the partition wall area PWA to surround the circuit area PCA. The first sub-layer SL1 may form an inorganic partition wall along with other sub-layers and an inorganic material layer. The first extension wiring 1201 and the second extension wiring 1203 may be spaced apart from the first sub-layer SL1 with the valley area VA therebetween. In some embodiments, the first sub-layer SL1 may be omitted.

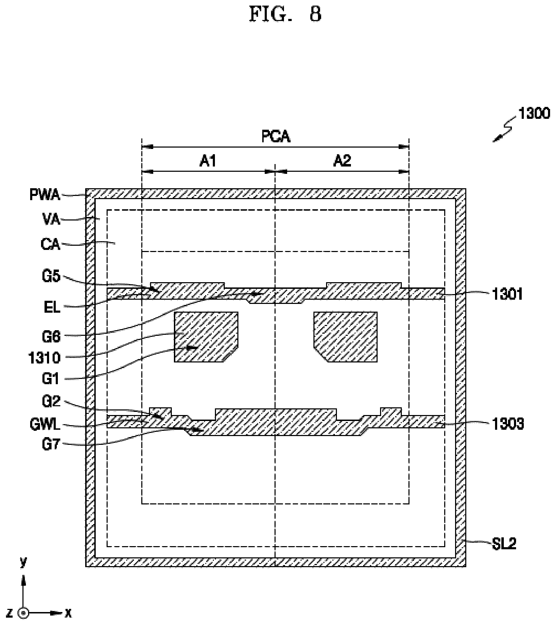

In an embodiment, as shown in FIG. 8, the first conductive layer 1300 may include a first conductive pattern 1310, the emission control line EL, the first scan line GWL, a fourth extension wiring 1301, a fifth extension wiring 1303, and a second sub-layer SL2. The first conductive pattern 1310, the emission control line EL, and the first scan line GWL may be located in the circuit area PCA, and the fourth extension wiring 1301 and the fifth extension wiring 1303 may be located in the connection area CA.

The first conductive pattern 1310 may have an island shape. A part of the first conductive pattern 1310 may overlap the first channel region C1 of the first semiconductor pattern 1210, to function as the first gate electrode G1 of the first transistor.

The emission control line EL may extend in the first direction (e.g., the x direction). A portion of the emission control line EL may overlap the fifth channel region C5 of the first semiconductor pattern 1210 to function as the fifth gate electrode G5 of the fifth transistor, and another portion of the emission control line EL may overlap the sixth channel region C6 of the first semiconductor pattern 1210 to function as the sixth gate electrode G6 of the sixth transistor. The emission control line EL may transmit an emission control signal to the fifth transistor and the sixth transistor.

The first scan line GWL may extend in the first direction (e.g., the x direction). A portion of the first scan line GWL may overlap the second channel region C2 of the first semiconductor pattern 1210 to function as the second gate electrode G2 of the second transistor, and another portion of the first scan line GWL may overlap the seventh channel region C7 of the second semiconductor pattern 1220 to function as the seventh gate electrode G7 of the seventh transistor. The first scan line GWL may transmit a first scan signal to the second transistor and the seventh transistor.

The fourth extension wiring 1301 may extend from the emission control line EL in the first direction (e.g., the x direction), and may overlap the third bridge line BM3. The fourth extension wiring 1301 may be integrally provided or formed with the emission control line EL as a single unitary and indivisible part.

The fifth extension wiring 1303 may extend from the first scan line GWL in the first direction (e.g., the x direction), and may overlap the sixth bridge line BM6. The fifth extension wiring 1303 may be integrally provided or formed with the first scan line GWL as a single unitary and indivisible part.

The second sub-layer SL2 may be located in the partition wall area PWA to surround the circuit area PCA. The second sub-layer SL2 may form an inorganic partition wall along with other sub-layers and an inorganic material layer. The fourth extension wiring 1301 and the fifth extension wiring 1303 may be spaced apart from the second sub-layer SL2 with the valley area VA therebetween. In some embodiments, the second sub-layer SL2 may be omitted.

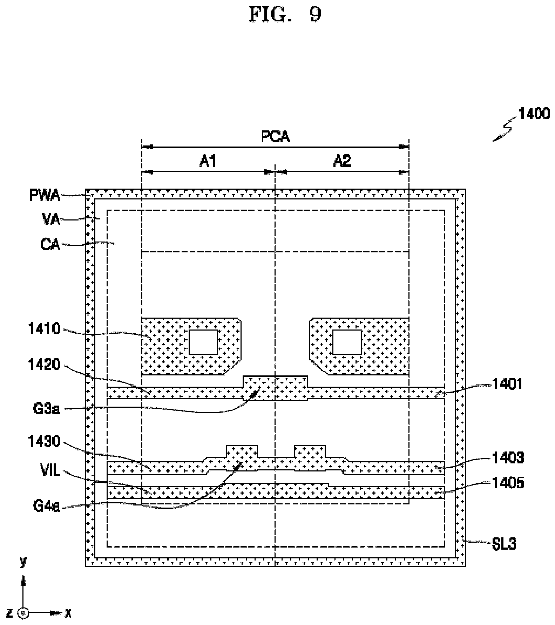

In an embodiment, as shown in FIG. 9, the second conductive layer 1400 may include a second conductive pattern 1410, a third wiring 1420, a fourth wiring 1430, the first initialization voltage line VIL, a sixth extension wiring 1401, a seventh extension wiring 1403, an eighth extension wiring 1405, and a third sub-layer SL3.

The second conductive pattern 1410, the third wiring 1420, the fourth wiring 1430, and the first initialization voltage line VIL may be located in the circuit area PCA.

The second conductive pattern 1410 may have an island shape. The second conductive pattern 1410 may overlap the first conductive pattern 1310. The second conductive pattern 1410 may correspond to the upper electrode CE2 described with reference to FIG. 4, and the first conductive pattern 1310 may correspond to the lower electrode CE1. The first conductive pattern 1310 and the second conductive pattern 1410 may overlap each other to form the storage capacitor Cst.

The third wiring 1420 may extend in the first direction (e.g., the x direction), and may include a third lower gate electrode G3a overlapping a third channel region C3 of the third semiconductor pattern 1510 described below. A width (or area) of the third lower gate electrode G3a may be greater than a width (or area) of the third channel region C3. The third wiring 1420 may be electrically connected to the second scan line GCL, to transmit a second scan signal to the third lower gate electrode G3a of the third transistor.

The fourth wiring 1430 may extend in the first direction (e.g., the x direction), and may include a fourth lower gate electrode G4a overlapping the fourth channel region C4 of the third semiconductor pattern 1510. A width (or area) of the fourth lower gate electrode G4a may be greater than a width (or area) of the fourth channel region C4. The fourth wiring 1430 may be electrically connected to the third scan line GIL, to transmit a third scan signal to a fourth lower gate electrode G4a of the fourth transistor.

The first initialization voltage line VIL may extend in the first direction (e.g., the x direction), and may be electrically connected to a third semiconductor pattern 1510 of the second semiconductor layer 1500 through an eighth conductive pattern 1760 described below. The first initialization voltage line VIL may transmit a first initialization voltage to the second terminal of the fourth transistor.

The sixth extension wiring 1401, the seventh extension wiring 1403, and the eighth extension wiring 1405 may be located in the connection area CA.

The sixth extension wiring 1401 may extend from the third wiring 1420 in the first direction (e.g., the x direction), and may overlap the fifth bridge line BM5. The sixth extension wiring 1401 may be integrally provided or formed with the third wiring 1420 as a single unitary and indivisible part.

The seventh extension wiring 1403 may extend from the fourth wiring 1430 in the first direction (e.g., the x direction), and may overlap the eighth bridge line BM8. The seventh extension wiring 1403 may be integrally provided or formed with the fourth wiring 1430 as a single unitary and indivisible part.

The eighth extension wiring 1405 may extend from the first initialization voltage line VIL in the first direction (e.g., the x direction), and may overlap the ninth bridge line BM9. The eighth extension wiring 1405 may be integrally provided or formed with the first initialization voltage line VIL as a single unitary and indivisible part.

The third sub-layer SL3 may be located in the partition wall area PWA to surround the circuit area PCA. The third sub-layer SL3 may form an inorganic partition wall along with other sub-layers and an inorganic material layer. The sixth extension wiring 1401, the seventh extension wiring 1403, and the eighth extension wiring 1405 may be spaced apart from the third sub-layer SL3 with the valley area VA therebetween. In some embodiments, the third sub-layer SL3 may be omitted.

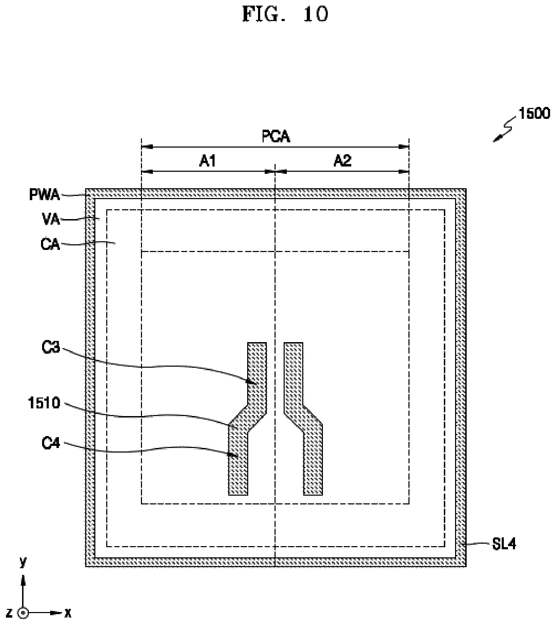

In an embodiment, as shown in FIG. 10, the second semiconductor layer 1500 may include the third semiconductor pattern 1510 and a fourth sub-layer SL4. The third semiconductor pattern 1510 may be located in the circuit area PCA.

The third semiconductor pattern 1510 may include the third channel region C3 and a fourth channel region C4. Impurity regions may be located on opposing sides of each channel region. Each of the impurity regions may be a source region or a drain region of a corresponding transistor.

The fourth sub-layer SL4 may be located in the partition wall area PWA to surround the circuit area PCA. The fourth sub-layer SL4 may form an inorganic partition wall along with other sub-layers and an inorganic material layer. In some embodiments, the fourth sub-layer SL4 may be omitted.

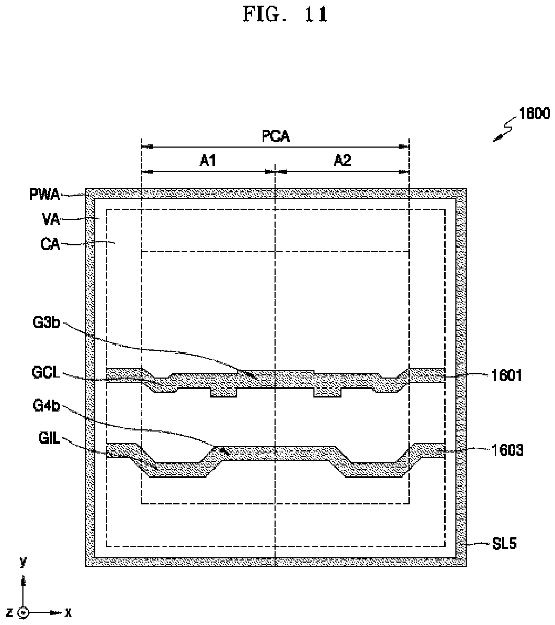

In an embodiment, as shown in FIG. 11, the third conductive layer 1600 may include the second scan line GCL, the third scan line GIL, a ninth extension wiring 1601, a tenth extension wiring 1603, and a fifth sub-layer SL5.

The second scan line GCL and the third scan line GIL may be located in the circuit area PCA, and the ninth extension wiring 1601 and the tenth extension wiring 1603 may be located in the connection area CA.

The second scan line GCL may extend in the first direction (e.g., the x direction), and may include the third upper gate electrode G3b overlapping the third channel region C3 of the third semiconductor pattern 1510. The third lower gate electrode G3a and the third upper gate electrode G3b may face each other with the third semiconductor pattern 1510 therebetween. The second scan line GCL may transmit a second scan signal to the third lower gate electrode G3a and the third upper gate electrode G3b of the third transistor.

The third scan line GIL may extend in the first direction (e.g., the x direction), and may include a fourth upper gate electrode G4b overlapping the fourth channel region C4 of the third semiconductor pattern 1510. The fourth lower gate electrode G4a and the fourth upper gate electrode G4b may face each other with the third semiconductor pattern 1510 therebetween. The third scan line GIL may transmit a third scan signal to the fourth lower gate electrode G4a and the fourth upper gate electrode G4b of the fourth transistor.

The ninth extension wiring 1601 may extend from the second scan line GCL in the first direction (e.g., the x direction), and may overlap the fourth bridge line BM4. The ninth extension wiring 1601 may be integrally provided or formed with the second scan line GCL as a single unitary and indivisible part.

The tenth extension wiring 1603 may extend from the third scan line GIL in the first direction (e.g., the x direction), and may overlap the seventh bridge line BM7. The tenth extension wiring 1603 may be integrally provided or formed with the third scan line GIL as a single unitary and indivisible part.

The fifth sub-layer SL5 may be located in the partition wall area PWA to surround the circuit area PCA. The fifth sub-layer SL5 may form an inorganic partition wall along with other sub-layers and an inorganic material layer. The ninth extension wiring 1601 and the tenth extension wiring 1603 may be spaced apart from the fifth sub-layer SL5 with the valley area VA therebetween. In some embodiments, the fifth sub-layer SL5 may be omitted.

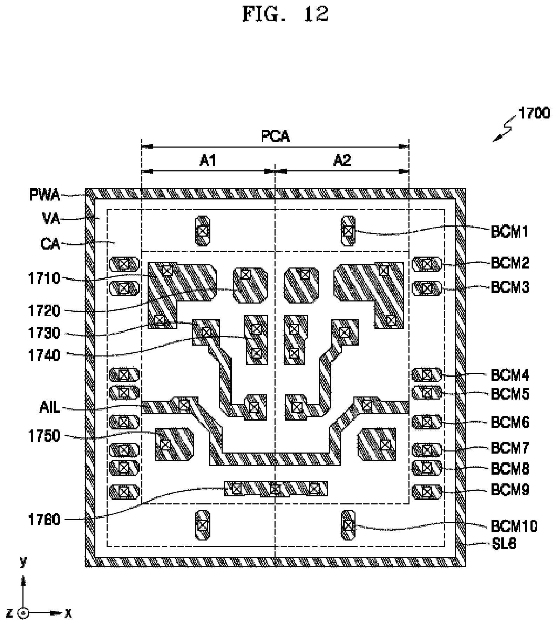

In an embodiment, as shown in FIG. 12, the fourth conductive layer 1700 may include a third conductive pattern 1710, a fourth conductive pattern 1720, a fifth conductive pattern 1730, a sixth conductive pattern 1740, a seventh conductive pattern 1750, an eighth conductive pattern 1760, the second initialization voltage line AIL, first to tenth bridge electrodes BCM1 to BCM10, and a sixth sub-layer SL6.

The third conductive pattern 1710, the fourth conductive pattern 1720, the fifth conductive pattern 1730, the sixth conductive pattern 1740, the seventh conductive pattern 1750, the eighth conductive pattern 1760, and the second initialization voltage line AIL may be located in the circuit area PCA.

The third conductive pattern 1710 may be connected to the first semiconductor pattern 1210 and the second conductive pattern 1410 through contact holes. The third conductive pattern 1710 may electrically connect the first terminal of the fifth transistor, the upper electrode CE2 of the storage capacitor Cst, and the driving voltage line PL (see FIG. 3).

The fourth conductive pattern 1720 may be connected to the first semiconductor pattern 1210 through a contact hole. The fourth conductive pattern 1720 may electrically connect the second terminal of the sixth transistor to a pixel electrode of the light-emitting diode. The fourth conductive pattern 1720 may correspond to the first connection electrode CM1 of FIG. 4.

The fifth conductive pattern 1730 may be connected to the first conductive pattern 1310 and the third semiconductor pattern 1510 through contact holes. The fifth conductive pattern 1730 may connect the first terminal of the third transistor T3 (see FIG. 3), the first terminal of the fourth transistor T4 (see FIG. 3), and the gate of the first transistor.

The sixth conductive pattern 1740 may be connected to the first semiconductor pattern 1210 and the third semiconductor pattern 1510 through contact holes. The sixth conductive pattern 1740 may connect the second terminal of the third transistor T3 (see FIG. 3) to the second terminal of the first transistor T1 (see FIG. 3).

The seventh conductive pattern 1750 may be connected to the first semiconductor pattern 1210 through a contact hole. The seventh conductive pattern 1750 may connect the first terminal of the second transistor T2 (see FIG. 3) to the data line DL (see FIG. 3).

The eighth conductive pattern 1760 may be electrically connected to the third semiconductor pattern 1510 and the first initialization voltage line VIL through contact holes. The eighth conductive pattern 1760 may connect the second terminal of the fourth transistor T4 (see FIG. 3) to the first initialization voltage line VIL.

The second initialization voltage line AIL may extend in the first direction (e.g., the x direction), and may be electrically connected to the second semiconductor pattern 1220 through contact holes. The second initialization voltage line AIL may transmit the second initialization voltage VAINT (see FIG. 3) to the second terminal of the seventh transistor T7 (see FIG. 3).

In some embodiments, the second initialization voltage line AIL may be electrically connected to neighboring pixel circuits to each other through a wiring located in a layer different from the fourth conductive layer 1700. In other embodiments, the second initialization voltage line AIL may extend to the connection area CA, the valley area VA, and the partition wall area PWA to be connected to neighboring pixel circuits. In this case, the sixth sub-layer SL6 may have a gap through which the second initialization voltage line AIL may pass. Alternatively, the sixth sub-layer SL6 may be omitted.

The first to tenth bridge electrodes BCM1 to BCM10 may be located in the connection area CA. The first to tenth bridge electrodes BCM1 to BCM10 may have island shapes.

The first bridge electrode BCM1 may overlap the first extension wiring 1201 and the first bridge line BM1. The first bridge electrode BCM1 may electrically connect the first extension wiring 1201 to the first bridge line BM1 through a contact hole.

The second bridge electrode BCM2 may overlap the second extension wiring 1203 and the second bridge line BM2. The second bridge electrode BCM2 may electrically connect the second extension wiring 1203 to the second bridge line BM2 through a contact hole.

The third bridge electrode BCM3 may overlap the fourth extension wiring 1301 and the third bridge line BM3. The third bridge electrode BCM3 may electrically connect the fourth extension wiring 1301 to the third bridge line BM3 through a contact hole.

The fourth bridge electrode BCM4 may overlap the ninth extension wiring 1601 and the fourth bridge line BM4. The fourth bridge electrode BCM4 may electrically connect the ninth extension wiring 1601 to the fourth bridge line BM4 through a contact hole.

The fifth bridge electrode BCM5 may overlap the sixth extension wiring 1401 and the fifth bridge line BM5. The fifth bridge electrode BCM5 may electrically connect the sixth extension wiring 1401 to the fifth bridge line BM5 through a contact hole.

The sixth bridge electrode BCM6 may overlap the fifth extension wiring 1303 and the sixth bridge line BM6. The sixth bridge electrode BCM6 may electrically connect the fifth extension wiring 1303 to the sixth bridge line BM6 through a contact hole.

The seventh bridge electrode BCM7 may overlap the tenth extension wiring 1603 and the seventh bridge line BM7. The seventh bridge electrode BCM7 may electrically connect the tenth extension wiring 1603 to the seventh bridge line BM7.

The eight bridge electrode BCM may overlap the seventh extension wiring 1403 and the eight bridge line BM8. The eighth bridge electrode BCM8 may electrically connect the seventh extension wiring 1403 to the eighth bridge line BM8 through a contact hole.

The ninth bridge electrode BCM9 may overlap the eighth extension wiring 1405 and the ninth bridge line BM9. The ninth bridge electrode BCM9 may electrically connect the eighth extension wiring 1405 to the ninth bridge line BM9 through a contact hole.

The tenth bridge electrode BCM 10 may overlap the third extension wiring 1205 and the tenth bridge line BM10. The tenth bridge electrode BCM10 may electrically connect the third extension wiring 1205 to the tenth bridge line BM10 through a contact hole.

The sixth sub-layer SL6 may be located in the partition wall area PWA to surround the circuit area PCA. The sixth sub-layer SL6 may form an inorganic partition wall along with other sub-layers and an inorganic material layer. The first to tenth bridge electrodes BCM1 to BCM10 may be spaced apart from the sixth sub-layer SL6 with the valley area VA therebetween. In some embodiments, the sixth sub-layer SL6 may be omitted.

The first sub-layer SL1 to the sixth sub-layer SL6 may be stacked on the substrate 100 (see FIG. 4) to form the inorganic partition wall PW (see FIG. 4). The inorganic material layers IL (see FIG. 4) may be located between the first sub-layer SL1 to the sixth sub-layer SL6.

In some embodiments, the inorganic partition wall PW may include the first sub-layer SL1 and/or the fourth sub-layer SL4 which is a semiconductor layer. In some embodiments, the inorganic partition wall PW may include the second sub-layer SL2, the third sub-layer SL3, the fifth sub-layer SL5, and the sixth sub-layer SL6 which are conductive layers. Some of the first sub-layer SL1 to the sixth sub-layer SL6 may be omitted.

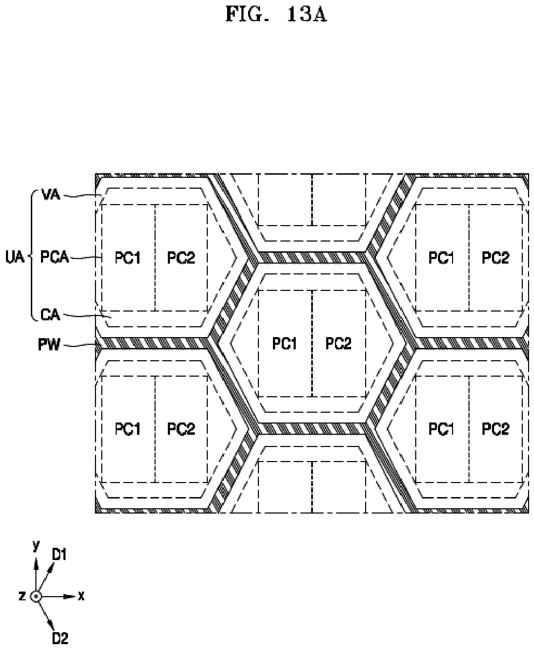

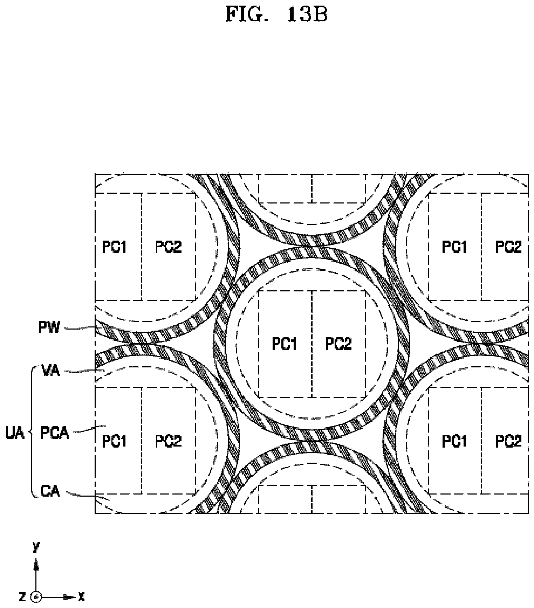

FIGS. 13A and 13B are plan views schematically illustrating a part of a display apparatus, according to embodiments.

Referring to FIGS. 13A and 13B, in an embodiment, the inorganic partition wall PW may be located to surround the circuit area PCA in which the first and second pixel circuits PC1 and PC2 are located.

The valley area VA may be located between the inorganic partition wall PW and the circuit area PCA. An opening or a groove defined in an inorganic material layer may be defined in the valley area VA. The connection area CA may be located between the circuit area PCA and the valley area VA. Extension wirings EP and bridge electrodes BCM for electrically connecting elements of the first and second pixel circuits PC1 and PC2 to a bridge line BM may be located in the connection area CA.

In a plan view, the inorganic partition wall PW may have a lattice structure over the entire display area.

In some embodiments, as shown in FIG. 13A, the inorganic partition wall PW may be formed when a partition wall extending in the first direction (e.g., the x direction), a partition wall extending in a third direction D1 intersecting the first direction (e.g., the x direction) and the second direction (e.g., the y direction), and a partition wall extending in a fourth direction D2 intersecting the first direction (e.g., the x direction) and the second direction (e.g., the y direction) meet each other at an intersection. In an embodiment, tThe inorganic partition wall PW may have a hexagonal lattice structure.

The hexagonal lattice structure distributes an external force when the display apparatus is bent due to the external force, and thus, may have a smaller load displacement than other lattice structures. Also, the hexagonal lattice structure may protect the first and second pixel circuits PC1 and PC2 from external impact such as pen drop. However, the disclosure is not limited thereto.

The inorganic partition wall PW may have a polygonal lattice structure such as a quadrangular lattice structure. Alternatively, the inorganic partition wall PW may have a circular lattice structure as shown in FIG. 13B or an elliptical lattice structure.

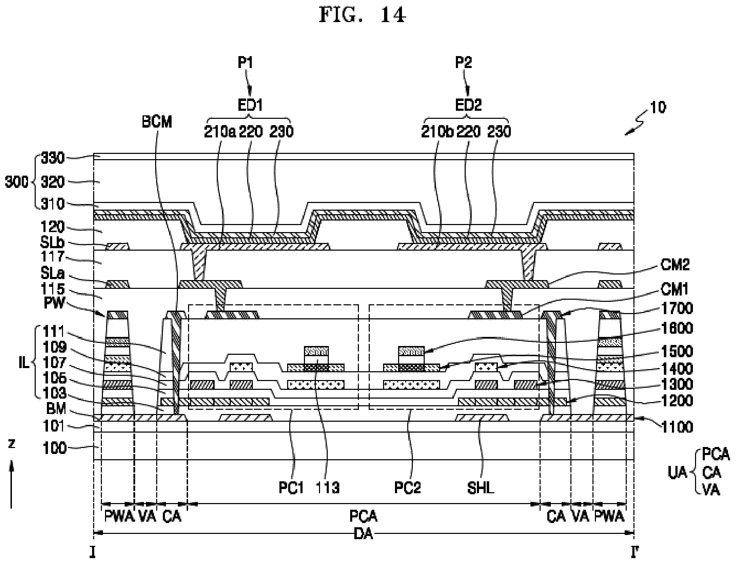

FIG. 14 is a cross-sectional view schematically illustrating a part of a display apparatus, according to an embodiment. FIG. 14 is similar to FIG. 4 except that a first inorganic pattern SLa located on the first planarization layer 115 and a second inorganic pattern SLb located on the second planarization layer 117 are further included. Any repetitive detailed description of the same or like elements as those described above will be omitted or simplified, and a difference will be mainly described.

Referring to FIG. 14, an embodiment of the display apparatus 10 may include the partition wall area PWA in which the inorganic partition wall PW is located and a unit area UA surrounded by the inorganic partition wall PW. Each unit area UA may include the circuit area PCA, in which pixel circuits are located, the valley area VA, and the connection area CA.

The barrier layer 101 may be located on the substrate 100, and the lower metal layer 1100 including the shield layer SHL and the bridge line BM may be located on the barrier layer 101. The bridge line BM may extend from the connection area CA through the valley area VA to cross the partition wall area PWA, and may electrically connect neighboring pixel circuits with the inorganic partition wall PW therebetween.

The inorganic material layer IL may be located on the lower metal layer 1100. The inorganic material layer IL may include the buffer layer 103, the first gate insulating layer 105, the second gate insulating layer 107, the first interlayer insulating layer 109, the third gate insulating layer 113, and the second interlayer insulating layer 111. The first semiconductor layer 1200, the first conductive layer 1300, the second conductive layer 1400, the second semiconductor layer 1500, the third conductive layer 1600, and the fourth conductive layer 1700 including elements of the first pixel circuit PC1 and the second pixel circuit PC2 may be located over and/or under the buffer layer 103, the first gate insulating layer 105, the second gate insulating layer 107, the first interlayer insulating layer 109, the third gate insulating layer 113, and the second interlayer insulating layer 111.

The inorganic material layer IL may define an opening or a groove in the valley area VA. The first planarization layer 115 may be located on the fourth conductive layer 1700. In some embodiments, the first planarization layer 115 may fill the opening or the groove of the inorganic material layer IL. The first planarization layer 115 may cover the inorganic partition wall PW.

The second connection electrode CM2 and the first inorganic pattern SLa may be located on the first planarization layer 115. The first inorganic pattern SLa and the second connection electrode CM2 may be formed through a same process and may include a same material as each other. The first inorganic pattern SLa may be located in the partition wall area PWA to overlap the inorganic partition wall PW.

The first pixel electrode 210a, the second pixel electrode 210b, and the second inorganic pattern SLb may be located on the second planarization layer 117. The second inorganic pattern SLb may be formed through a same process as the first pixel electrode 210a and the second pixel electrode 210b, and may include a same material as the first pixel electrode 210a and the second pixel electrode 210b. The second inorganic pattern SLb may be located in the partition wall area PWA to overlap the inorganic partition wall PW. In some embodiments, any one of the first inorganic pattern SLa and the second inorganic pattern SLb may be omitted.

Because the first inorganic pattern SLa and the second inorganic pattern SLb having a high modulus are included, stress due to external force may be distributed, the first and second pixel circuits PC1 and PC2 may be protected, and thus, the display apparatus 10 that is robust against external impact may be implemented.

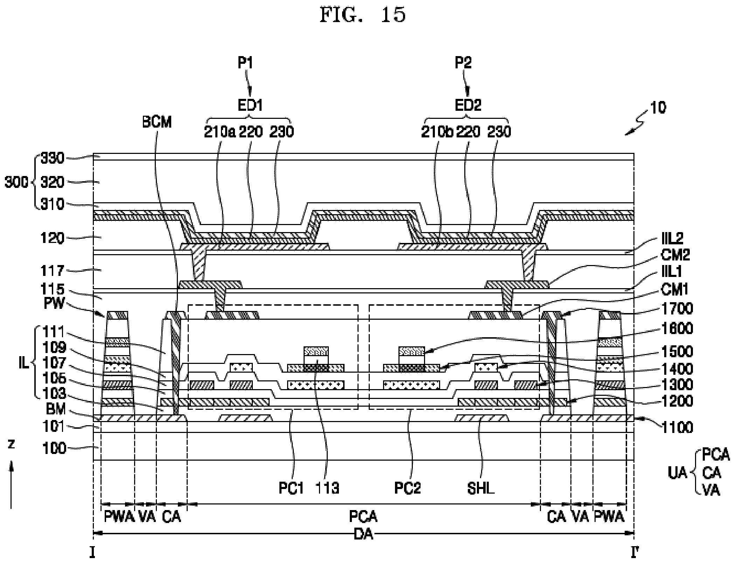

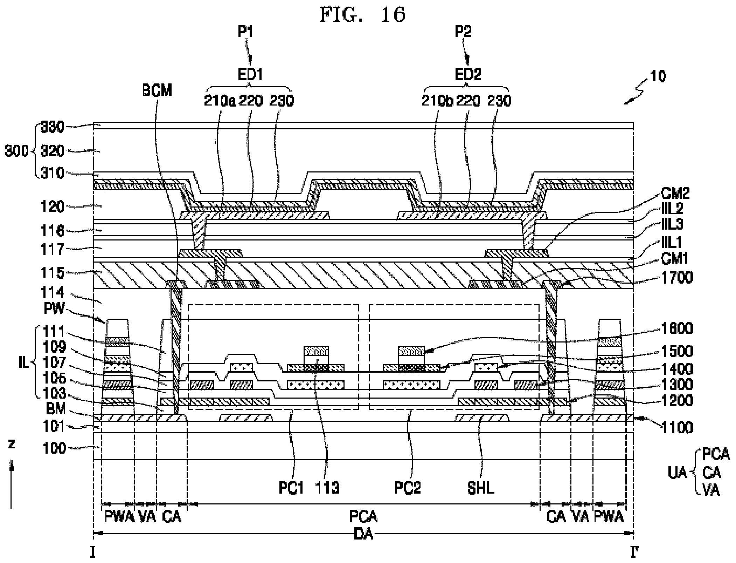

FIGS. 15 and 16 are cross-sectional views schematically illustrating a part of a display apparatus, according to embodiments. FIGS. 15 and 16 are similar to FIG. 4 except that a composite layer in which one or more inorganic insulating layers and one or more organic insulating layers are stacked is located between the first and second pixel circuits PC1 and PC2 and the first and second light-emitting diodes ED1 and ED2. Any repetitive detailed description of the same or like elements as those described above will be omitted or simplified, and a difference will be mainly described.

Referring to FIG. 15, in an embodiment, a first inorganic insulating layer IIL1 may be located between the second connection electrode CM2 and the first planarization layer 115 (first organic insulating layer) covering the inorganic partition wall PW. In such an embodiment, a second inorganic insulating layer IIL2 may be located between the first and second pixel electrodes 210a and 210b and the second planarization layer 117 (second organic insulating layer) covering the second connection electrode CM2.

Each of the first inorganic insulating layer IIL1 and the second inorganic insulating layer IIL2 may include an inorganic material such as oxide or nitride, and may have a single or multi-layer structure. In an embodiment, for example, each of the first inorganic insulating layer IIL1 and the second inorganic insulating layer IIL2 may include silicon oxide, silicon nitride, and/or silicon oxynitride.

The first planarization layer 115, the first inorganic insulating layer IIL1, the second planarization layer 117, and the second inorganic insulating layer IIL2 may be defined as a composite layer located between the first and second pixel circuits PC1 and PC2 and the first and second light-emitting diodes ED1 and ED2. In some embodiments, any one of the first inorganic insulating layer IIL1 and the second inorganic insulating layer IIL2 may be omitted.

Because the first inorganic insulating layer 11L1 and the second inorganic insulating layer IIL2 having high strength are located over and/or under the first planarization layer 115 and the second planarization layer 117 including an organic material, the composition layer may absorb and distribute external impact.

In a comparative example, when a pen drop test was performed on a display apparatus in which an inorganic material layer does not include a groove or an opening and a composite layer is not applied, cracks occurred when a pen was dropped from a height of 3 cm or higher. In another comparative example, when a pen drop test was performed on a display apparatus in which an inorganic material layer includes a groove or an opening but a composite layer is not applied, cracks occurred when a pen was dropped from a height of 7 cm or higher. In another comparative example, when a pen drop test was performed on a display apparatus in which an inorganic material layer does not include a groove or an opening and a composite layer is applied, cracks occurred when a pen was dropped from a height of 6 cm or higher. According to an embodiment, when a pen drop test was performed on a display apparatus in which an inorganic material layer includes a groove or an opening and a composite layer is applied, cracks occurred when a pen was dropped from a height of 9 cm or higher. Accordingly, it is found that when a composite layer is applied, robustness of the display apparatus against external impact increases.

Referring to FIG. 16, in an alternative embodiment, the composite layer may further include a third organic insulating layer 114, a fourth organic insulating layer 116, and a third inorganic insulating layer IIL3.

The third organic insulating layer 114 may be located between the second interlayer insulating layer 111 and the first planarization layer 115. The third organic insulating layer 114 may fill a groove or an opening of the inorganic material layer IL, and may provide a flat base surface to elements located on the third organic insulating layer 114.

The third inorganic insulating layer IIL3 may be located on the second planarization layer 117. The third inorganic insulating layer IIL3 may include an inorganic material such as oxide or nitride, and may have a single or multi-layer structure. In an embodiment, for example, the third inorganic insulating layer IIL3 may include silicon oxide, silicon nitride, and/or silicon oxynitride.

The fourth organic insulating layer 116 may be located between the third inorganic insulating layer IIL3 and the second inorganic insulating layer IIL2. In some embodiments, the first inorganic insulating layer IIL1 or the second inorganic insulating layer IIL2 may be omitted. In some embodiments, the third organic insulating layer 114 or the fourth organic insulating layer 116 may be omitted.

Each of the third organic insulating layer 114 and the fourth organic insulating layer 116 may include an organic insulating material. In an embodiment, for example, each of the third organic insulating layer 114 and the fourth organic insulating layer 116 may include a general-purpose polymer such as benzocyclobutene (BCB), polyimide, hexamethyldisiloxane (HMDSO), polymethyl methacrylate (PMMA) or polystyrene (PS), a polymer derivative having a phenol-based group, an acrylic polymer, an imide-based polymer, an aryl ether-based polymer, an amide-based polymer, a fluorinated polymer, a p-xylene-based polymer, or a vinyl alcohol-based polymer.

Because the composite layer further includes the third organic insulating layer 114 and/or the fourth organic insulating layer 116, a flatness of a top surface of the composite layer may be improved and the display apparatus 10 that is more robust against external impact may be implemented.

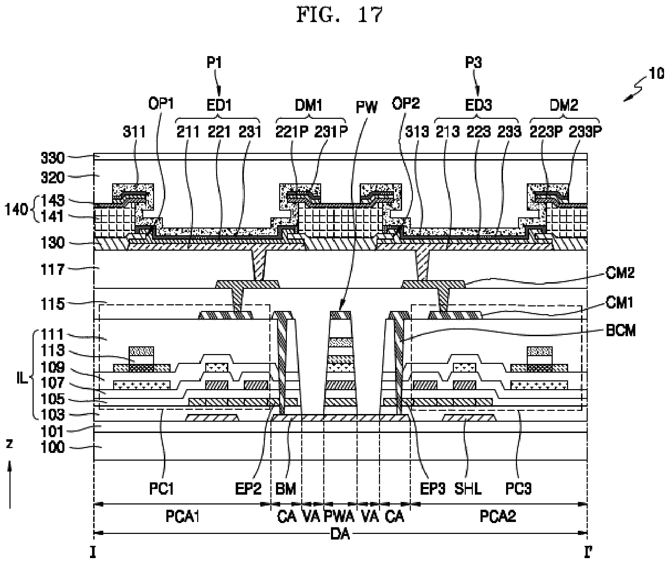

FIG. 17 is a cross-sectional view schematically illustrating a part of a display apparatus, according to an embodiment. FIG. 17 is similar to FIG. 4 except that a first bank layer 130 and a second bank layer 140, instead of the pixel-defining film 120, are included.

Referring to FIG. 17, in an embodiment, the display area DA may include a first circuit area PCA1 in which a first pixel circuit PC1 is located and a second circuit area PCA2 in which a third pixel circuit PC3 is located. The partition wall area PWA, the valley area VA, and the connection area CA may be located between the first circuit area PCA1 and the second circuit area PCA2. The inorganic partition wall PW may be located in the partition wall area PWA, and a groove or an opening defined by the inorganic material layer IL may be located in the valley area VA.

The inorganic partition wall PW may be located in the partition wall area PWA, and may have a loop shape surrounding the circuit area PCA. In a plan view, the inorganic partition wall PW may have a lattice structure. The inorganic partition wall PW may be located on the bridge line BM, and may include a plurality of sub-layers. The sub-layers may be formed in a same process as layers constituting the first pixel circuit PC1 and the third pixel circuit PC3, and may include a same material as the layers constituting the first pixel circuit PC1 and the third pixel circuit PC3.

The bridge line BM may extend from the connection area CA to cross the valley area VA and the partition wall area PWA, and may electrically connect the first pixel circuit PC1 and the third pixel circuit PC3 adjacent to each other with the inorganic partition wall PW therebetween. In an embodiment, for example, each of an extension wiring EP1 of the first pixel circuit PC1 and an extension wiring EP3 of the third pixel circuit PC3 may be electrically connected to the bridge line BM through the bridge electrode BCM.

The first pixel circuit PC1 may be electrically connected to the first light-emitting diode ED1, and the third pixel circuit PC3 may be electrically connected to a third light-emitting diode ED3. The first planarization layer 115 and the second planarization layer 117 may be located between the first and third pixel circuits PC1 and PC3 and the first and third light-emitting diodes ED1 and ED3. The first connection electrode CM1 may be located on the second interlayer insulating layer 111, and the second connection electrode CM2 may be located between the first planarization layer 115 and the second planarization layer 117. The first and third light-emitting diodes ED1 and ED3 may be respectively electrically connected to the first and third pixel circuits PC1 and PC3 through the first connection electrode CM1 and the second connection electrode CM2.

The first light-emitting diode ED1 and the third light-emitting diode ED3 may be located on the second planarization layer 117. The first light-emitting diode ED1 may include a first pixel electrode 211, a first counter electrode 231, and a first intermediate layer 221 located between the first pixel electrode 211 and the first counter electrode 231. The third light-emitting diode ED3 may include a third pixel electrode 213, a third counter electrode 233, and a third intermediate layer 223 located between the third pixel electrode 213 and the third counter electrode 233. The first light-emitting diode ED1 and the third light-emitting diode ED3 may have substantially a same structure as or similar structures to each other. The features of the first light-emitting diode ED1 described above may apply to the third light-emitting diode ED3.

The first pixel electrode 211 may be located on the second planarization layer 117. The first pixel electrode 211 may be electrically connected to the second connection electrode CM2 through a contact hole defined through the second planarization layer 117.

The first pixel electrode 211 may be a (semi-)transmissive electrode or a reflective electrode. In some embodiments, the first pixel electrode 211 may include a reflective layer formed of Ag, Mg, AI, Pt, Pd, Au, Ni, Nd, Ir, Cr, or a compound thereof, and a transparent or semi-transparent electrode layer formed on the reflective layer. The transparent or semi-transparent electrode layer may include at least one selected from indium tin oxide (ITO), indium zinc oxide (IZO), zinc oxide (ZnO), indium oxide (In₂O₃), indium gallium oxide (IGO), and aluminum zinc oxide (AZO). In some embodiments, the first pixel electrode 211 may include ITO/Ag/ITO.

According to an embodiment, each of the plurality of display elements may comprise a pixel electrode 211, a counter electrode 230, and an emission layer located between the pixel electrode 211 and the counter electrode 230. In an embodiment, the display apparatus 10 may further comprise an inorganic bank layer 130 located on the pixel electrode 211 and defining a pixel opening through which a central portion of the pixel electrode 211 is exposed, and a metal bank layer 140 located on the inorganic bank layer 130 and defining a first opening overlapping the pixel opening.

In an embodiment, the metal bank layer may overlap the inorganic partition wall PW.

The first bank layer 130 may be located on the first pixel electrode 211 to cover an edge of the first pixel electrode 211. The first bank layer 130 may define a first pixel opening OP1 through which a central portion of the first pixel electrode 211 is exposed and a second pixel opening OP2 through which a central portion of the third pixel electrode 213 is exposed. The first bank layer 130 may include an inorganic material such as silicon oxide, silicon nitride, and/or silicon oxynitride, and may have a single or multi-layer structure. The first bank layer 130 may increase a distance between an edge of the first pixel electrode 211 and the first counter electrode 231, thereby preventing an arc or the like from occurring between the edge of the first pixel electrode 211 and the first counter electrode 231.

A residual sacrificial layer may be located between the first bank layer 130 and edge of the first pixel electrode 211. The residual sacrificial layer may be a portion of a layer for preventing the first pixel electrode 211 from being damaged by a gas or liquid material used in an etching process or an ashing process included in a manufacturing process of the display apparatus 10. The residual sacrificial layer may overlap the first pixel opening OP1, to define an opening through which a top surface of the first pixel electrode 211 is exposed. The residual sacrificial layer may include a conductive oxide such as IZO and/or IGZO.

The second bank layer 140 may be located on the first bank layer 130. The second bank layer 140 may include a first sub-metal layer 141 and a second sub-metal layer 143 located on the first sub-metal layer 141. The first sub-metal layer 141 and the second sub-metal layer 143 may include metals having different etch selectivities from each other. In an embodiment, for example, the first sub-metal layer 141 may include aluminum or molybdenum, and the second sub-metal layer 143 may include titanium or tantalum.

The first sub-metal layer 141 may define a first opening overlapping the first pixel opening OP1. The second sub-metal layer 143 may define a second opening overlapping the first pixel opening OP1. A width (or area) of the first opening defined in the first sub-metal layer 141 may be greater than a width (or area) of the second opening defined in the second sub-metal layer 143. In other words, a part of the first sub-metal layer 141 located under the second sub-metal layer 143 may be removed to form an undercut structure in which the second sub-metal layer 143 protrudes. The second sub-metal layer 143 may include a tip protruding from a side surface of the first sub-metal layer 141 defining the first opening to a center of the first opening.

The first intermediate layer 221 may be located on the first pixel electrode 211. The first intermediate layer 221 may include an emission layer. The emission layer may include a high molecular weight organic material or a low molecular weight organic material that emits light of a certain color (e.g., red light, green light, or blue light). In an alternative embodiment, the emission layer may include an inorganic material or quantum dots. The first intermediate layer 221 may include a functional layer located between the first pixel electrode 211 and the emission layer and/or between the emission layer and the first counter electrode 231. The first intermediate layer 221 may be located in the first pixel opening OP1, and a third intermediate layer 223 may be located in the second pixel opening OP2.

In an embodiment, the counter electrode 230 may directly contact the side surface of the first sub-metal layer 141 defining the first opening. The first counter electrode 231 may be located on the first intermediate layer 221. The first counter electrode 231 may directly contact a side surface of the first sub-metal layer 141 defining the first opening. The first counter electrode 231 may receive the second driving voltage ELVSS (see FIG. 3) through the second bank layer 140.

The first counter electrode 231 may be formed of a conductive material having a low work function. In an embodiment, for example, the first counter electrode 231 may include a (semi-)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the first counter electrode 231 may further include a layer including or formed of ITO, IZO, ZnO, or In₂O₃ on the (semi-)transparent layer including at least one selected from the above materials.

A first dummy stack DM1 may be located on a top surface of the second sub-metal layer 143 adjacent to the first pixel opening OP1. The first dummy stack DM1 may include a first dummy layer 221P and a second dummy layer 231P. The first dummy layer 221P may include the same material as the first intermediate layer 221, and the second dummy layer 231P may include a same material as the first counter electrode 231. The first intermediate layer 221 and the first dummy layer 221P may be separated and spaced apart from each other by the tip of the second sub-metal layer 143. The first counter electrode 231 and the second dummy layer 231P may be separated and spaced apart from each other by the tip of the second sub-metal layer 143. In a plan view, the first dummy stack DM1 may have a closed-loop shape.

Likewise, a second dummy stack DM2 may be located on a top surface of the second sub-metal layer 143 adjacent to the second pixel opening OP2. The second dummy stack DM2 may include a third dummy layer 223P and a fourth dummy layer 233P. The third dummy layer 223P may include a same material as the third intermediate layer 223, and the fourth dummy layer 233P may include a same material as the third counter electrode 233. The third intermediate layer 223 and the third dummy layer 223P may be separated and spaced apart from each other by the tip of the second sub-metal layer 143. The third counter electrode 233 and the fourth dummy layer 233P may be separated and spaced apart from each other by the tip of the second sub-metal layer 143. In a plan view, the second dummy stack DM2 may have a closed-loop shape.

A first first inorganic encapsulation layer 311 may be located on the first counter electrode 231, and a third first inorganic encapsulation layer 313 may be located on the third counter electrode 233. Each of the first first inorganic encapsulation layer 311 and the third first inorganic encapsulation layer 313 may include an inorganic material such as silicon oxide, silicon nitride, and/or silicon oxynitride, and may have a single or multi-layer structure.

Because the first first inorganic encapsulation layer 311 has relatively excellent step coverage, the first first inorganic encapsulation layer 311 may directly contact a surface of the tip of the second sub-metal layer 143 exposed from the first sub-metal layer 141 and a side surface of the first sub-metal layer 141, to form an inorganic contact area completely surrounding the first light-emitting diode ED1. Accordingly, the first first inorganic encapsulation layer 311 may block or reduce a path through which impurities penetrate into the first light-emitting diode ED1.

Likewise, because the third first inorganic encapsulation layer 313 has relatively excellent step coverage, the third first inorganic encapsulation layer 313 may directly contact a surface of the tip of the second sub-metal layer 143 exposed from the first sub-metal layer 141 and a side surface of the first sub-metal layer 141, to form an inorganic contact area completely surrounding the third light-emitting diode ED3.

The first first inorganic encapsulation layer 311 and the third first inorganic encapsulation layer 313 may be spaced apart from each other. In an embodiment, for example, the first first inorganic encapsulation layer 311 may be patterned into an island shape to cover the first light-emitting diode ED1, and the third first inorganic encapsulation layer 313 may be patterned into an island shape to cover the third light-emitting diode ED3.

The organic encapsulation layer 320 may be located on the first first inorganic encapsulation layer 311 and the third first inorganic encapsulation layer 313. The organic encapsulation layer 320 may provide a flat base surface to elements located on the organic encapsulation layer 320. The organic encapsulation layer 320 may include a polymer-based material. Examples of the polymer-based material may include an acrylic resin, an epoxy resin, polyimide, and polyethylene.

The second inorganic encapsulation layer 330 may be located on the organic encapsulation layer 320. The second inorganic encapsulation layer 330 may include an inorganic material such as silicon oxide, silicon nitride, and/or silicon oxynitride, and may have a single or multi-layer structure.

In some embodiments, the first bank layer 130 and the second bank layer 140 may be located in the partition wall area PWA to overlap the inorganic partition wall PW. That is, the first pixel opening OP1 and the second pixel opening OP2 may be spaced apart from the inorganic partition wall PW in a plan view. Because the first bank layer 130 and the second bank layer 140 have a high modulus, the first bank layer 130 and the second bank layer 140 may sufficiently protect the first and third pixel circuits PC1 and PC3 from external impact.

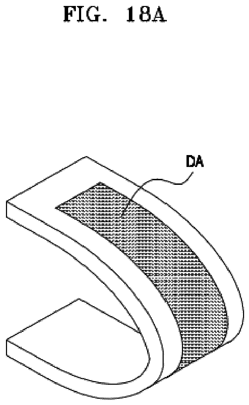

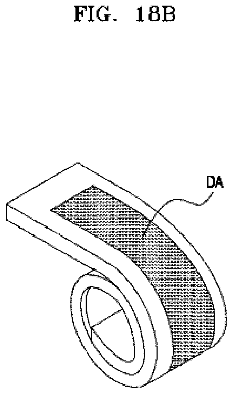

FIGS. 18A and 18B are views schematically illustrating a display apparatus, according to embodiments. FIG. 18A illustrates the display apparatus in a state where the display area DA is folded. FIG. 18B illustrates the display apparatus in a state where the display area DA is rolled.

Because the display apparatus according to embodiments is robust against external impact as described above, the display apparatus may be foldable or rollable as shown in FIGS. 18A and 18B.

In embodiments, an inorganic partition wall having a lattice structure for distributing and absorbing external impact is located between pixel circuits, such that the display apparatus may reduce external impact transmitted to a pixel circuit even when the display area DA is folded or rolled. In embodiments, the display apparatus includes an opening or a groove defined in an inorganic material layer, such that an organic material layer filling the opening or the groove may absorb stress caused by an external force.

According to an embodiment as described above, a display apparatus that includes an inorganic partition wall and is flexible but robust against external impact may be implemented.

The invention should not be construed as being limited to the embodiments set forth herein. Rather, these embodiments are provided so that this disclosure will be thorough and complete and will fully convey the concept of the invention to those skilled in the art.

## Claims

1. A display apparatus (10) comprising:
a substrate (100) on which a display area (DA) and a peripheral area (DPA) outside the display area (DA) are defined;
a plurality of pixel circuits located in the display area (DA), wherein each of the plurality of pixel circuits comprises a thin-film transistor;
a plurality of display elements connected to the plurality of pixel circuits, respectively;
an inorganic partition wall (PW) located between the plurality of pixel circuits; and
a bridge line (BM) crossing the inorganic partition wall (PW) to electrically connect neighboring pixel circuits (PC) among the plurality of pixel circuits, which neighbor each other with the inorganic partition wall (PW) therebetween, to each other.

2. The display apparatus (10) of claim 1, further comprising:
an inorganic material layer (IL) located on the bridge line (BM) in the display area (DA); and
a bridge electrode (BCM) located between the plurality of pixel circuits and the inorganic partition wall (PW) and overlapping the bridge line (BM) in a plan view,
wherein each of the plurality of pixel circuits comprises an extension wiring (EP) overlapping the bridge line (BM) and extending toward the inorganic partition wall (PW),
wherein the bridge electrode (BCM) is connected to the bridge line (BM) through a contact hole defined through the inorganic material layer (IL) and is connected to the extension wiring (EP).

3. The display apparatus (10) of claim 2, wherein the inorganic material layer (IL) defines an opening or a groove in a second area of the display area (DA) between the inorganic partition wall (PW) and the first area.

4. The display apparatus (10) of claim 2 or 3, wherein the extension wiring (EP) is located in a third area of the display area (DA) between the first area and the second area.

5. The display apparatus (10) of any of claims 2 to 4, wherein the bridge electrode (BCM) is located in the third area.

6. The display apparatus (10) of any of claims 1 to 5, wherein the thin-film transistor comprises a semiconductor layer (1200, 1500) and a gate electrode (G1, G2, G3, G4, G5) overlapping the semiconductor layer (1200, 1500),
wherein the bridge line (BM) is located between the substrate (100) and the semiconductor layer (1200, 1500).

7. The display apparatus (10) of any of claims 1 to 6, wherein the inorganic partition wall (PW) comprises one or more conductive layers (1300, 1400, 1600, 1700).

8. The display apparatus (10) of any of claims 1 to 7, further comprising:
a first organic insulating layer (115) covering the inorganic partition wall (PW); and
an inorganic pattern (SLa) located on the first organic insulating layer (115) and overlapping the inorganic partition wall (PW).

9. The display apparatus (10) of any of claims 1 to 8, further comprising:
a composite layer located between the plurality of pixel circuits and the plurality of display elements, wherein the composite layer comprises one or more inorganic insulating layers and one or more organic insulating layers, which are stacked one on another.

10. The display apparatus (10) of any of claims 1 to 9, further comprising:
a connection electrode layer located between the plurality of pixel circuits and the plurality of display elements,
wherein the composite layer comprises:
a first organic insulating layer (115) covering the inorganic partition wall (PW);
a first inorganic insulating layer (IIL1) between the first organic insulating layer (115) and the connection electrode layer;
a second organic insulating layer (117) on the connection electrode layer; and
a second inorganic insulating layer (IIL2) between the second organic insulating layer and the plurality of display elements.

11. The display apparatus (10) of claim 10, wherein the composite layer further comprises:
a third organic insulating layer (114) between the first organic insulating layer (115) and the plurality of pixel circuits;
a third inorganic insulating layer (IIL3) on the second organic insulating layer (117); and
a fourth organic insulating layer (116) between the third inorganic insulating layer (IIL3) and the second inorganic insulating layer (IIL2).

12. The display apparatus (10) of any of claims 1 to 11, wherein each of the plurality of display elements comprises a pixel electrode (211), a counter electrode (230), and an emission layer located between the pixel electrode (211) and the counter electrode (230),
wherein the display apparatus (10) further comprises:
an inorganic bank layer (130) located on the pixel electrode (211) and defining a pixel opening through which a central portion of the pixel electrode (211) is exposed; and
a metal bank layer (140) located on the inorganic bank layer (130) and defining a first opening overlapping the pixel opening.

13. The display apparatus (10) of claim 12, wherein the metal bank layer (140) overlaps the inorganic partition wall (PW).

14. The display apparatus (10) of claim 12 or 13, wherein the pixel opening and the first opening are spaced apart from the inorganic partition wall (PW), in a plan view.

15. The display apparatus (10) of any of claims 12 to 14, wherein the metal bank layer (140) comprises a first sub-metal layer (141) and a second sub-metal layer (143) located on the first sub-metal layer (141),
wherein the second sub-metal layer (143) comprises a tip protruding from a side surface of the first sub-metal layer (141) defining the first opening toward a center of the first opening.
